(19) Europäisches Patentamt
European Patent Office
Office européen des brevets

(11) **EP 4 016 645 B1**

(12) **EUROPEAN PATENT SPECIFICATION**

(45) Date of publication and mention
of the grant of the patent:
**13.08.2025 Bulletin 2025/33**

(21) Application number: **20216084.2**

(22) Date of filing: **21.12.2020**

(51) International Patent Classification (IPC):
*H10D 12/01* (2025.01)    *H10D 30/66* (2025.01)
*H10D 62/10* (2025.01)    *H10D 62/832* (2025.01)

(52) Cooperative Patent Classification (CPC):
**H10D 12/031; H10D 30/668; H10D 62/117;
H10D 62/8325;** H10D 64/256; H10D 64/518;
H10D 64/519

(54) **SILICON CARBIDE POWER DEVICE AND METHOD FOR MANUFACTURING THE SAME**

SILICIUMCARBID-LEISTUNGSVORRICHTUNG UND VERFAHREN ZUR HERSTELLUNG DAVON

DISPOSITIF D'ALIMENTATION AU CARBURE DE SILICIUM ET SON PROCÉDÉ DE FABRICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**22.06.2022 Bulletin 2022/25**

(73) Proprietor: **Hitachi Energy Ltd
8050 Zürich (CH)**

(72) Inventors:
• **Wirths, Stephan
8800 Thalwil (CH)**
• **Knoll, Lars
5607 Hägglingen (CH)**

(74) Representative: **Epping - Hermann - Fischer
Patentanwaltsgesellschaft mbH
Schloßschmidstraße 5
80639 München (DE)**

(56) References cited:
**WO-A1-2020/114666    GB-A- 2 572 442
US-A1- 2017 365 665    US-A1- 2019 165 162
US-B1- 10 056 289**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

FIELD OF THE INVENTION

The present invention relates to a method for manufacturing a silicon carbide device.

BACKGROUND OF THE INVENTION

Silicon carbide (SiC) offers a number of attractive characteristics for power semiconductor devices when compared to commonly used silicon (Si). Exemplarily, the much higher breakdown field strength and thermal conductivity of SiC allow power devices which outperform by far the corresponding Si ones, and enable reaching otherwise unattainable efficiency levels. 4H-SiC is the preferred polytype for power electronics, such as metal-oxide-semiconductor field effect transistors (MOSFETs) due to the advances in the field of 4H-SiC growth technology as well as its attractive electronic properties such as the larger band gap over other available wafer-scale polytypes, e.g. 6H-SiC or 3C-SiC. Although, those 4H-SiC power MOSFETs are already commercially available, there is large room for improvements, especially regarding inversion channel mobility in order to further decrease on-resistance $R_{on}$.

Most of the commercially available power field effect transistors based on silicon carbide (SiC) are implemented with a planar design, where a channel is formed on a surface of a wafer, such as in a vertical double diffused metal oxide semiconductor field effect transistor (VDMOS). However, current densities in these devices are difficult to increase since the p-type implantations in an n-channel VDMOS form the gates of a parasitic junction field effect transistor (JFET) that tend to reduce the width of the current flow.

Trench metal oxide semiconductor field effect transistors (MOSFETs) enable the achievement of low on-resistance $R_{on}$ because of lack of the parasitic JFET. Additionally, for SiC, the trench MOSFET architecture permits optimization of carrier mobility by designing the channel with respect to different crystallographic planes. A SiC trench MOSFET is known for example from US 2018/0350977 A1. In this known trench MOSFET, a plurality of channel regions are implemented as part of a continuous p-type body layer. The trench-type gate electrodes are arranged in trenches which are separate from each other. In this configuration the on-resistance $R_{on}$ is relatively high due to a relatively low device area that can be used for the channel regions. Channel inversion is not possible in the whole body layer but only in areas of the body layer laterally interposed between adjacent trench-type gate electrodes. Known methods for manufacturing SiC based trench MOSFETS rely on etching a deep trench into SiC for forming the trench-type gate electrodes. Etching SiC is difficult and costly compared to etching other semiconductor materials such as silicon (Si).

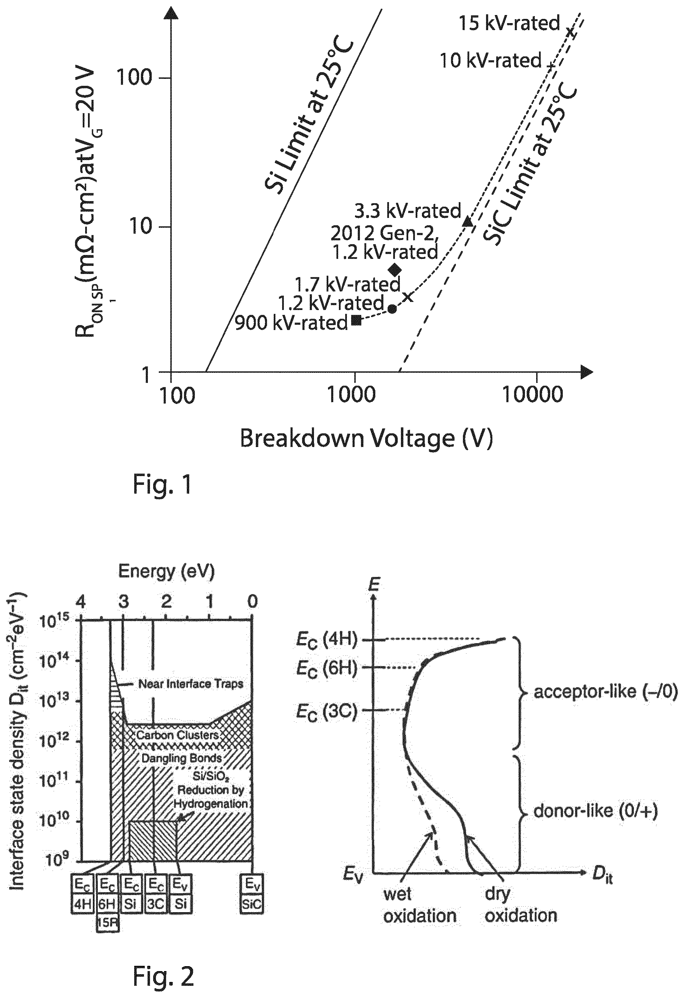

Whereas for higher voltage classes >3 kV the drift layer resistance $R_{drift}$ dominates on-resistance $R_{on}$, reduction of the latter is, however, essential in commercially more relevant lower voltage classes (e.g. voltage classes ≤1.7 kV) - used for electric and hybrid electric vehicles (EVs/HEVs) - in order to significantly reduce the on-state power and switching losses. Here, $R_{on}$ is still considerably higher than ideal as shown in FIG. 1. In this respect, low inversion channel mobility represents one of the main challenges that might have significant impact on device costs and hence wide spread adoption of SiC power MOSFETs. Boosting the inversion channel mobility using improved gate stacks as well as SiC/oxide interfaces showed limited success, but is known as one of the most important milestones in the development and commercialization of SiC power MOSFETs. In the late 90s, the introduction of nitric oxide (NO) post-oxidation for 6H-SiC and its application to 4H-SiC MOSFETs in 2001 enabled an enormous increase in inversion layer electron mobility, because the introduction of nitrogen (N) near the interface via NO annealing reduces the interface defect density $D_{it}$. However, there is a strong demand for higher mobility devices beyond state-of-the-art NO annealed SiC MOSFETs particularly in order to expand SiC MOSFETs into the low voltage classes markets.

Furthermore, problems that could be avoided by a higher channel mobility in addition to reach ideal/lower $R_{on}$ are as follows:

a) the gate can be driven at lower voltages resulting in smaller electric fields in the gate oxide layer, which improves threshold stability and oxide long term reliability, and

b) aggressive scaling of the transistor channel length is not required in order to reduce the channel resistance, thus, short channel effects can be avoided.

Alternative strategies to reduce interface defects beyond the NO treatment are the introduction of interfacial layers with trace impurities, surface counter-doping, higher temperature oxidations and alternative non-polar crystal faces (instead of conventional polar Si-face) due to their inherently high mobility.

From the publication 'Improved inversion channel mobility for 4H-SiC MOSFETs following high temperatures anneals in nitric oxide', G.Y. Chung et. al, IEEE Electron device letters, vol. 22, No. 4, April 2001, pages 176-178, it is known a method for manufacturing a 4H-SiC MOSFET in which the channel mobility of a lateral, inversion-mode 4H-SiC MOSFET is increased significantly after passivation of SiC/SiO$_2$ interface states near the conduction band edge by high temperature anneals in nitric oxide.

Documents GB 2 572 442 A, US 2019/0165162 A1, US 2017/0365665 A1, US 10 056 289 B1 and WO 2020/114666 A1 refer to semiconductor devices.

SUMMARY OF THE INVENTION

In view of the above disadvantages in the prior art, it is an object of the invention to provide a method for manufacturing a silicon carbide power device with lower on-resistance $R_{on}$. The object of the invention is attained by a method according to claim 1. Further developments of the invention are specified in the dependent claims. Embodiments which are not covered by the invention should be considered as examples useful for understanding the invention.

A thus manufactured silicon carbide power device according to an embodiment comprises a first conductivity-type substrate having a first main side and a second main side opposite to the first main side, a plurality of silicon carbide layer stacks arranged on the first main side of the substrate, a continuous insulating layer and a gate electrode layer. Each silicon carbide layer stack comprises the following layers stacked on the first main side in a direction away from the first main side: a first conductivity-type drain layer on the substrate, a second conductivity-type channel layer on the drain layer and a first conductivity-type source layer on the channel layer, the second conductivity-type being different from the first conductivity-type. The continuous insulating layer comprises a plurality of first insulating layer portions respectively extending directly on a lateral surface of one of the plurality of silicon carbide layer stacks so that the plurality of first insulating layer portions laterally cover and laterally surround at least the drain layer and the channel layer of each silicon carbide layer stack, and a second insulating layer portion extending on the first main side between the plurality of first insulating layer portions. The gate electrode layer extends directly on the first insulating layer such that the gate electrode layer is electrically separated from each one of the silicon carbide layer stacks by the first insulating layer portions. Each silicon carbide layer stack has a shape of a pillar protruding from the first main side, such that each point of each channel layer is laterally sandwiched between two opposing portions of the gate electrode layer, wherein the two opposing portions of the gate electrode layer have a distance of less than 2 $\mu$m along a straight line extending through that point of that channel layer.

Throughout the specification, if a first layer extends directly on a second layer that shall mean that the first layer is in direct physical contact with the second layer with no other layer or element sandwiched between the first layer and the second layer (at least where the first layer directly extends on the second layer).

The silicon carbide power device having the above structure has a relatively low on-resistance $R_{on}$ due to the specific arrangement of the source regions, channel regions and drain regions in the plurality of laterally separated vertical silicon carbide structures. Compared to prior art SiC based trench MOSFETs in which the channel regions are only portions in a continuous body layer, a larger area of the device can be used for a conducting channel in which carrier inversion takes place in the on-state. That means, while in the prior art SiC based trench MOSFET not all portions of the continuous body layer are channel regions in which carrier inversion takes place in the on-state, in the silicon carbide power device having above structure a larger area of the device can be used for a carrier inversion region. In the silicon carbide power device having above structure, the insulating layer laterally covers and laterally surrounds the drain layer and the channel layer of each silicon carbide layer stack to define the lateral extension of the drain layer and of the channel layer. A continuous gate electrode layer laterally surrounding each channel layer may be used, whereas in the prior art SiC based trench MOSFETs the trench gate electrodes are laterally separated and have to be contacted from the top. Also, the silicon carbide power device having the above structure has the advantage to not necessarily require an edge termination.

In an embodiment, the channel layer comprises 3C-SiC and the drain layer comprises 4H-SiC or 6H-SiC.

In this embodiment, the idea is to combine the advantages of two SiC polytypes, i.e. 3C-SiC and 4H-SiC or alternatively 3C-SiC and 6H-SiC, to enable high performance SiC power MOSFETs. Whereas, 4H-SiC or alternatively 6H-SiC employed in the drain layer (which may form at least part of a drift layer) ensures good blocking capability due to its higher band gap, 3C-SiC is employed as a channel material, since channel motilities exceeding 160 cm$^2$/vs have been measured in 3C-SiC. In the case of SiC, near interface traps (NITs) are an important class of interface defects, which can be found inside the oxide very close to the interface in Si and SiC MOS structures. For the latter, they are responsible for the high concentration of neutral defect states near the conduction band edge ($E_C$-$E_T$<0.2 eV) as shown in Fig. 2. However, the distribution and density of NITs strongly depend on the polytype of SiC. While the density of NITs increases nearly exponentially towards the conduction band edge for 4H-SiC or 6H-SiC, it remains relatively low for 3C-SiC. In addition, defect states in the lower half of the band gap (close to the valence band, see Fig. 2) are donor-like and do not directly affect the n-type carrier mobility. Defect states near the conduction band, however are acceptor-like and can be negatively charged, for instance if a gate voltage is applied. As a consequence, electrons in the inversion channel are trapped, become almost immobile and act as coolant scattering centers, which significantly limits the n-channel mobility. Therefore, 3C-SiC/oxide interfaces in power MOSFET devices exhibit lower interface defect density $D_{it}$ and as a consequence higher channel mobility compared to their 4H-SiC/oxide or 6H-SiC/oxide counterparts.

In an embodiment the substrate has a doping concentration above $10^{17}$ cm$^{-3}$ or above $5.10^{17}$ cm$^{-3}$, and the drain layer of each silicon carbide layer stack is in direct contact with the substrate. In such embodiment no low doped drift layer has to be formed on a highly doped substrate, because a whole drift layer of the device can be implemented in the drain layer. Accordingly, the device is less complex and may be manufactured with less method steps.

In an embodiment each silicon carbide layer stack has the shape of the pillar and the first insulating layer portions are tube-shaped, respectively surrounding laterally a corresponding one of the plurality of silicon carbide layer stacks to form a plurality of vertical gate-all-around field effect transistor cells. Gate-all-around field effect transistor cells allow a most efficient gate control. In this embodiment, the channel layer of each silicon carbide layer stack may have a largest horizontal width in any horizontal direction parallel to the first main side which largest horizontal width is below 2 μm, exemplarily below 1 μm.

In an embodiment the insulating layer is a silicon oxide layer or a silicon nitride layer.

A method for manufacturing the silicon carbide power device according to any one of the preceding embodiments comprises the following steps:

- providing the substrate;

- forming a sacrificial layer on the first main side of the substrate;

- structuring the sacrificial layer to form a plurality of sacrificial structures protruding from the first main side and having a shape of a pillar, wherein each sacrificial structure comprises a first end adjacent to the substrate and a second end opposite to the first end (i.e. the second end is an end of the sacrificial structure which is furthest away from the substrate);

- forming a continuous insulating material layer on the plurality of sacrificial structures and on the first main side;

- thereafter removing a portion of the insulating material layer on the second end of each sacrificial structure to expose the second end of each sacrificial structure, while the remaining insulating material layer covers a lateral surface of each sacrificial structure, wherein at least a part of the remaining insulating material layer forms the insulating layer in the silicon carbide power device;

- thereafter removing each sacrificial structure by selective etching to form a plurality of cavities in the remaining insulating material layer, wherein an exposed portion of the first main side is exposed at a bottom of each cavity;

- forming a first silicon carbide layer of the first conductivity-type selectively on the exposed portion of the first main side in each cavity to form the drain layers;

- forming a second silicon carbide layer of the second conductivity-type selectively on the first silicon carbide layer in each cavity to form the channel layers;

- forming a third silicon carbide layer of the first conductivity-type selectively on the second silicon carbide layer in each cavity to form the source layers; and

- forming the gate electrode layer on that part of the remaining insulating material layer which forms the insulating layer in the silicon carbide power device.

Compared to the known methods for manufacturing the known SiC based trench-type power MOSFETs no step of etching a deep trench in SiC is required in the above method. This facilitates manufacturing in view of the difficulties to form deep trenches in SiC by etching.

In an exemplary embodiment the sacrificial layer comprises amorphous silicon.

In an exemplary embodiment the insulating material layer is formed by thermal oxidation. Thermal oxidation allows to form the insulating material layer with very stable oxide material providing good properties for the gate insulating layer and having good mechanical characteristics, which is advantageous for use of the insulating material layer as a gate dielectric.

In an exemplary embodiment the method comprises a step of forming a second insulating layer on the remaining insulating material layer before forming the gate electrode layer, such that after forming the gate electrode layer, the second insulating layer is sandwiched in a vertical direction perpendicular to the first main side between the remaining insulating material layer and the gate electrode layer. Exemplarily, the second insulating layer is a spin-on-glass (SOG) layer. The second insulating layer decreases a parasitic capacitance of the gate electrode layer.

In an exemplary embodiment each sacrificial structure has a length in a vertical direction perpendicular to the first main side in a range between 50 nm and 10 $\mu$m, exemplarily in a range between 5 and 10 $\mu$m.

In an exemplary embodiment forming the first silicon carbide layer, forming the second silicon carbide layer and forming the third silicon carbide layer is respectively performed at a temperature below 1400°C. Temperatures above 1400°C may damage the remaining insulating material layer which is used as a gate dielectric in the silicon carbide power device. For example a silicon oxide material is damaged at temperatures above 1400°C.

In an exemplary embodiment, the step of removing the portion of the insulating material layer on the second end of each sacrificial structure comprises a first step of forming a continuous first masking material layer on the insulating material layer, a second step of etching back the first masking material layer to form a first masking layer exposing the portion of the insulating material layer on the second end of each sacrificial structure, and a third step of etching the portion of the insulating material layer on the second end using the first masking layer as an etching mask.

In an exemplary embodiment the method comprises a step of removing a portion of the third silicon carbide layer to expose a portion of the second silicon carbide layer, and thereafter a step of forming a first main electrode electrically contacting the third silicon carbide layer and the second silicon carbide layer, wherein the first main electrode is electrically insulated from the gate electrode layer.

BRIEF DESCRIPTION OF THE DRAWINGS

Detailed embodiments of the invention will be explained below with reference to the accompanying figures, in which:

FIG. 1 illustrates the performance of state-of-the-art 4H-SiC power MOSFETs;

FIG. 2 illustrates the distribution of interface states inside the band gap of various SiC polytypes;

FIG. 3A shows a manufactured silicon carbide power device in a vertical cross-section along line C-C' in FIG. 3D;

FIG. 3B shows a top view of the silicon carbide power device of FIG. 3A;

FIG. 3C shows a single transistor cell in the silicon carbide power device of FIG. 3A;

FIG. 3D shows a horizontal cross-section of the silicon carbide power device along line A-A' in FIG. 3A;

FIGs. 4A to 4L illustrate method steps in a method for manufacturing the silicon carbide power device of FIG. 3A;

FIG. 5 shows a vertical cross-section of a silicon carbide power device according to a first modification;

FIG. 6 shows a vertical cross-section of a silicon carbide power device according to a second modification;

FIG. 7 shows a vertical cross-section of a silicon carbide power device according to a third modification;

FIG. 8 shows a horizontal cross-section of a silicon carbide power device according to a fourth modification not covered by the claims but useful for understanding the invention;

FIG. 9 shows a horizontal cross-section of a silicon carbide power device according to a fifth modification not covered by the claims but useful for understanding the invention;

FIG. 10 shows a vertical cross-section of a silicon carbide power device according to a sixth modification;

FIG. 11 shows a vertical cross-section of a silicon carbide power device according to a seventh modification; and

FIGs. 12A to 12H illustrate methods steps in a method for manufacturing the silicon carbide power device of FIG. 11.

The reference signs used in the figures and their meanings are summarized in the list of reference signs. Generally, similar elements have the same reference signs throughout the specification. The described embodiments are meant as examples and shall not limit the scope of the invention.

**EP 4 016 645 B1**

DETAILED DESCRIPTION OF EXEMPLARY EMBODIMENTS

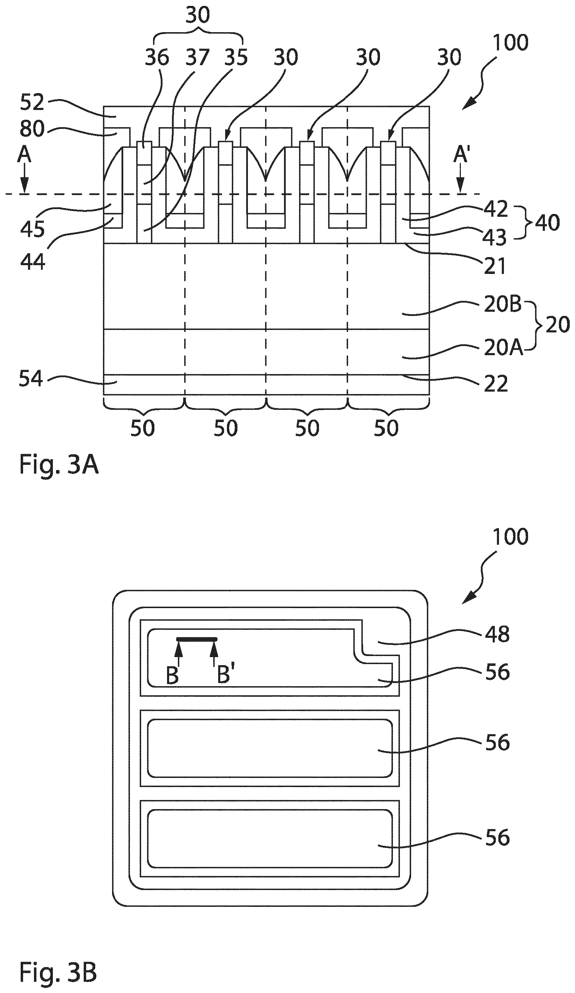

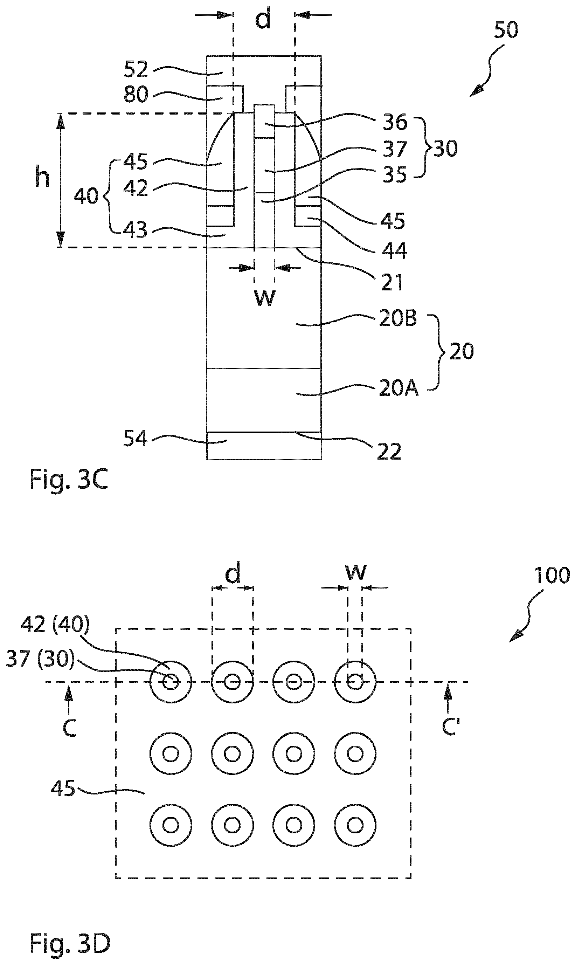

In the following a silicon carbide power device 100 is described with reference to FIGs. 3A to 3D. The silicon carbide power device 100 is a silicon carbide based power metal-insulator-semiconductor field effect transistor (MISFET). FIG. 3A shows a vertical cross-section of four transistor cells 50 in the silicon carbide power device 100 along a line B-B' in FIG. 3B, which shows a top view of the silicon carbide power device 100, and along line C-C' in FIG. 3D, which shows a horizontal cross-section of the silicon carbide power device 100 along line A-A' in FIG. 3A. FIG. 3C shows an enlarged cross-section of a single transistor cell 50 in the silicon carbide power device of FIG. 3A.

As can be seen best from FIGs. 3A and 3C the silicon carbide power device 100 comprises an n-type substrate 20 having a first main side 21 and a second main side 22 opposite to the first main side 21. As shown in FIGs. 3A to 3D, the substrate 20 comprises in an order from the second main side 22 to the first main side 21 an n-type first substrate layer 20A and an n-type second substrate layer 20B. The first substrate layer 20A is relatively highly doped and exemplarily has a doping concentration above $10^{17}$ cm$^{-3}$, exemplarily above $10^{18}$ cm$^{-3}$. The second substrate layer 20B is relatively low doped and exemplarily has a doping concentration below $10^{17}$ cm$^{-3}$, exemplarily below $10^{16}$ cm$^{-3}$. In the silicon carbide power device 100 the second substrate layer 20B functions as a drift layer portion common to all transistor cells 50. Exemplarily, the first substrate layer 20A may comprise a 4H-SiC layer, a 6H-SiC layer, a 3C-SiC layer or a silicon layer. The second substrate layer 20B may exemplarily be one of a 4H-SiC layer, a 6H-SiC layer, or a 3C-SiC layer. Compared to a second substrate layer 20B made of 3C-SiC, using a second substrate layer 20B made of 4H-SiC or made of 6H-SiC has the advantage that a blocking capability and thermal characteristics are improved due to a relatively large band gap of 4H-SiC or 6H-SiC. The second substrate layer 20B may be an epitaxial layer grown hetero-epitaxially or homo-epitaxially on the first substrate layer 20A.

A plurality of silicon carbide layer stacks 30 are arranged on the first main side 21 of the substrate 20. Each silicon carbide layer stack 30 comprises the following layers stacked on the first main side 21 in a direction away from the first main side 21 (see FIG. 3C): an n-type drain layer 35 on the substrate 20, a p-type channel layer 37 and an n-type source layer 36 on the channel layer 37. As illustrated in the top view in FIG. 3D the plurality of silicon carbide layer stacks 30 may be arranged on the first main side 21 in form of a matrix when viewed from a vertical direction onto the first main side 21.

A continuous insulating layer 40 is arranged on the substrate 20 laterally between the silicon carbide layer stacks 30. Throughout the specification the term lateral or laterally refers to a lateral direction parallel to the first main side 21. Likewise, the term vertical or vertically refers to a vertical direction perpendicular to the first main side 21. The insulating layer 40 comprises a plurality of tube-shaped first insulating layer portions 42 respectively extending directly on a lateral surface of one of the plurality of silicon carbide layer stacks 30 and comprises a second insulating layer portion 43 extending on the first main side 21 between the plurality of first insulating layer portions 42. The plurality of first insulating layer portions 42 laterally cover and laterally surround at least the drain layer 35 and the channel layer 37 of each silicon carbide layer stack 30. This can be seen best in the vertical cross-section of FIG. 3C and in the horizontal cross-section of FIG. 3D. Exemplarily, the first insulating layer portions 42 laterally cover and laterally surround also a portion of the source layer 36 as shown in FIGs. 3A and 3C. If a first layer laterally covers a second layer, it means that the first layer fully overlaps the second layer when viewed in any lateral direction. Also if the first layer laterally surrounds the second layer this shall mean that the first layer surrounds the second layer in an orthogonal projection onto a plane parallel to the first main side 21. For each first insulating layer portion 42, there is a direct contact between that first insulating layer portion 42 with the lateral surfaces of the channel layer 37 and the drain layer 35 which are laterally surrounded by that first insulating layer portion 42. The first insulating layer 40 is exemplarily a silicon oxide layer or a silicon nitride layer. Exemplarily, the first insulating layer 40 is a thermal oxide layer.

A gate electrode layer 45 is arranged and extends directly on the first insulating layer 40 such that the gate electrode layer 45 and each one of the plurality of silicon carbide layer stacks 30 are separated from each other by a corresponding one of the plurality of first insulating layer portions 42. If two elements are separated from each other by a third element, then this means that the two elements are not directly connected with each other but both elements are directly connected to the third element separating the two elements. Exemplarily, the gate electrode layer 45 is a continuous layer laterally surrounding each silicon carbide layer stack 30. Exemplarily, each point of the gate electrode layer 45 is closer to the first main side 21 than each point of a first main electrode 52 described below, i.e. the whole gate electrode layer extends at a level below the first main electrode 52.

A second insulating layer 44 is sandwiched in a vertical direction perpendicular to the first main side 21 between the second insulating layer portion 43 and the gate electrode layer 45. The second insulating layer 44 separates the gate electrode layer 45 farther away from the substrate 20 to minimize a parasitic capacitance of the gate electrode layer 45. The second insulating layer 44 may be of any electrically insulating material. For example, it may be a spin-on glass (SOG) layer.

Each transistor cell 50 comprises one of the plurality of silicon carbide layer stacks 30, one of the plurality of first insulating layer portions 42 and a portion of the gate electrode layer 45 as described above to form a vertical gate-all-around field effect transistor cell.

Each silicon carbide layer stack 30 has a shape of a pillar protruding from the first main side 21, such that each point of each channel layer 37 is laterally sandwiched between two opposing portions of the gate electrode layer 45, wherein the two opposing portions of the gate electrode layer 45 have a distance d of less than 2 $\mu$m along a straight line extending through that point of that channel layer 37. In FIGs. 3A to 3D, the distance d is identical to a diameter of the tube-shaped first insulating layer portions 42. In FIG. 3D C-C' is an example for such a straight line going through all points of the channel layer 37 where that straight line C-C' intersects the channel layer 37. The channel layer 37 of each silicon carbide layer stack 30 has a largest horizontal width w in any horizontal direction parallel to the first main side 21 which is below 2 $\mu$m, exemplarily below 1 $\mu$m. A layer thickness (d-w)/2 of the first insulating layer portions 42 (wherein w is the largest horizontal width and d is the diameter of the tube-shaped first insulating layer portions 42) is exemplarily in a range between 5 and 500 nm. The shape of a pillar may exemplarily have a height h in a vertical direction perpendicular to the first main side 21 larger than the largest horizontal width w. Exemplarily, the height h might be at least 2 or 3 times larger than the largest horizontal width w.

The source layer 36, the channel layer 37 and the drain layer 35 may be any SiC polytype. These layers may be of different SiC polytypes or of the same SiC polytype. At least the channel layer 37 may comprise 3C-SiC whereas the drain layer 35 may comprise 4H-SiC or 6H-SiC. The second substrate layer 20B and the drain layer 35 may be of the same SiC polytype. For example, the channel layer 37 may be of 3C-SiC, whereas the second substrate layer 20B and the drain layer 35 may be both of 4H-SiC or may be both of 6H-SiC.

As shown in FIGs. 3A and 3C, the silicon carbide power device 100 comprises an intermediate insulating layer 80 arranged on the gate electrode layer 45 and the first main electrode 52 arranged on the intermediate insulating layer 80. The first main electrode 52 is separated from the gate electrode layer 45 by the intermediate insulating layer 80 to be electrically insulated therefrom. Through openings 80A in the intermediate layer 80, the first main electrode 52 is in electrical contact with the source layer 36 of each one of the plurality of silicon carbide layer stacks 30. On the second main side 22 a second main electrode 54 is arranged.

Referring to the top view of FIG. 3B, an upper portion of the first main electrode 52 is a source contact pad 56 and serving as a source terminal of the silicon carbide power device 100. Alternatively, the source contact pad 56 may be implemented as a separate element electrically connected to the first main electrode 52. Throughout the specification, a lower portion of an element is to be understood as a portion adjacent to the first main side 21 and an upper portion of the element is to be understood as a portion opposite to the lower portion in a vertical direction, i.e. each point of the lower portion is closer to the first main side 21 than each point of the upper portion. The gate electrode layer 45 extending below the first main electrode 52 is electrically connected to a control contact pad 48 serving as a gate terminal of the silicon carbide power device 100. In FIG. 3D the control contact pad 48 is arranged lateral to the source contact pad 56. That means that while the source layers are connected to the source contact pad 56 from the top, the gate electrode layer is connected to the gate electrode layer 45 from a lateral side of the silicon carbide power device 100, i.e. in an orthogonal projection onto a plane parallel to the first main side 21, and the source contact pad 56 overlaps the plurality of transistor cells 50 including the plurality of silicon carbide layer stacks 30 while the control contact pad 48 is arranged lateral to the plurality of transistor cells 50.

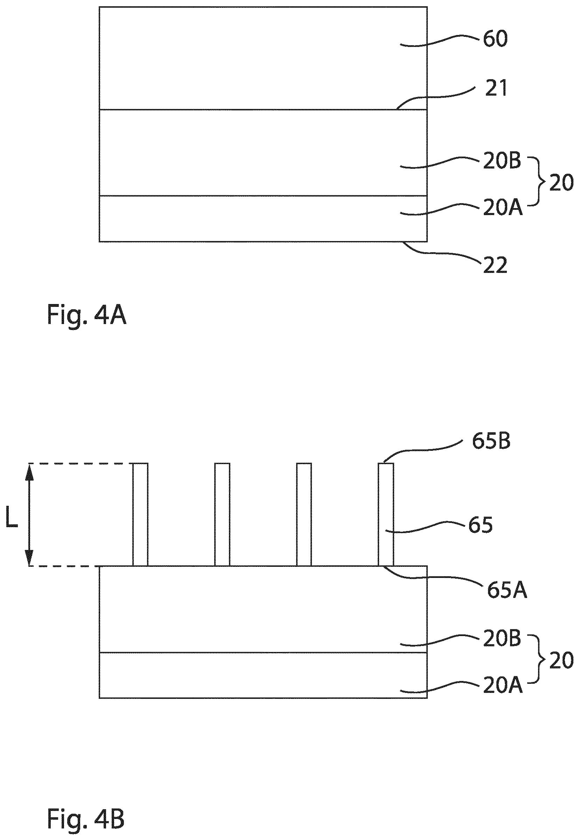

In the following a method for manufacturing the silicon carbide power device 100 as described above will be described with reference to FIGs. 4A to 4L, which show vertical cross-sections of intermediate structures corresponding to the vertical cross-section of the final silicon carbide power device 100 shown in FIG. 3A.

In a first method step the substrate 20 having the first main side 21 and the second main side 22 is provided. The second substrate layer 20B may be deposited onto the first substrate layer 20A by a chemical vapour deposition (CVD) process, for example. Alternatively, the two-layered structure of the substrate 20 may be formed by implantation of an n-type dopant into an n-type preliminary substrate to form the first substrate layer 20A and the second substrate layer 20B having different doping concentrations as discussed above.

In another method step a sacrificial layer 60 is formed on the first main side 21 to obtain a structure as shown in FIG. 4A in a vertical cross-section.

In another method step the sacrificial layer 60 is structured to form a plurality of sacrificial structures 65 protruding from the first main side 21 as shown in FIG. 4B. Each sacrificial structure 65 has a shape of a pillar and comprises a first end 65A adjacent to the substrate 20 and a second end 65B opposite to the first end 65A in a vertical direction perpendicular to the first main side 21. The second end 65B is an end of the sacrificial structure 65 furthest away from the substrate 20. Exemplarily each sacrificial structure 65 has a length L in a vertical direction perpendicular to the first main side 21 in a range between 50 nm and 10 $\mu$m, exemplarily in a range between 5 $\mu$m and 10 $\mu$m.

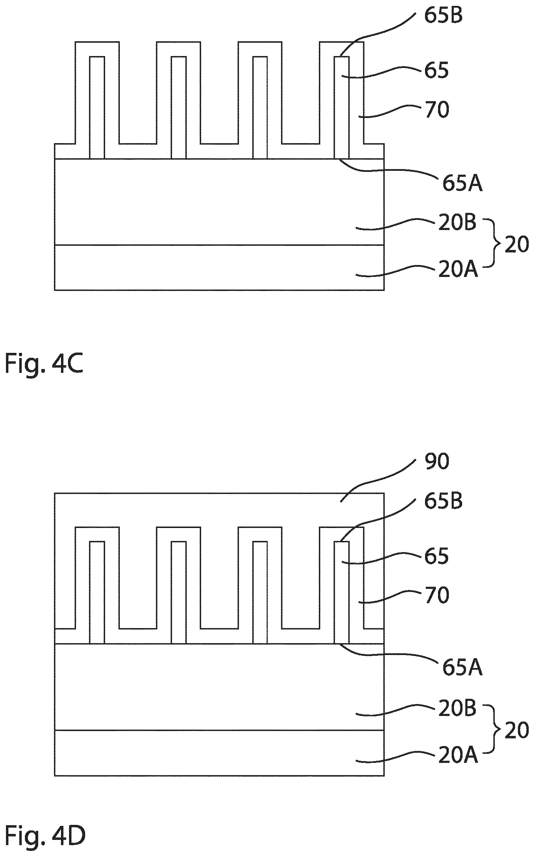

In another method step a continuous insulating material layer 70 is formed on the plurality of sacrificial structures 65 and on the first main side 21 exposed by the sacrificial structures 65 to obtain a structure as shown in FIG. 4C. The sacrificial layer 60 may be a carbon layer or a silicon layer, for example. In an exemplary embodiment, the sacrificial layer 60 is a poly-silicon (poly-Si) layer or an amorphous silicon layer and second substrate layer 20B is a SiC layer. In this exemplary embodiment, the insulating material layer 70 may be a thermal oxide layer formed by thermal oxidation of the sacrificial structures 65 and of exposed portions of the second substrate layer 20B. Alternatively, the insulating material layer 70 can be formed by a deposition process such as by plasma enhanced CVD (PE-CVD) or another appropriate deposition process. Exemplarily, the insulating material layer 70 is a silicon oxide or a silicon nitride layer.

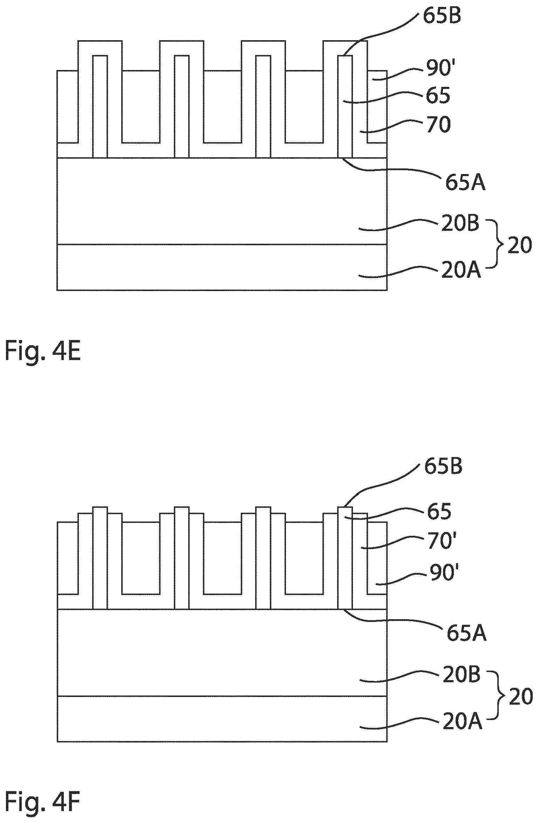

In another method step, a portion of the insulating material layer 70 on the second end 65B of each sacrificial structure 65 is removed to expose the second end 65B of each sacrificial structure 65, while the remaining insulating material layer 70' covers a lateral surface of each sacrificial structure 65 (as shown in FIG. 4F). Therein, at least a part of the remaining insulating material layer 70' forms the insulating layer 40 in the silicon carbide power device 100. Exemplarily, this method step of removing the portion of the insulating material layer 70 on the second end 65B of each sacrificial structure 65 may comprise the following sub-steps illustrated in FIGs. 4D to 4F:

- a first sub-step of forming a continuous first masking material layer 90 on the insulating material layer 70 as shown in FIG. 4D;
- a second sub-step of etching back the first masking material layer 90 to form a first masking layer 90' exposing the portion of the insulating material layer 70 on the second end 65B of each sacrificial structure 65 as shown in FIG. 4E, and
- a third sub-step of etching the portion of the insulating material layer 70 on the second end 65B using the first masking layer 90' as an etching mask to obtain a structure as shown in FIG. 4F, and thereafter removing the first masking layer 90'.

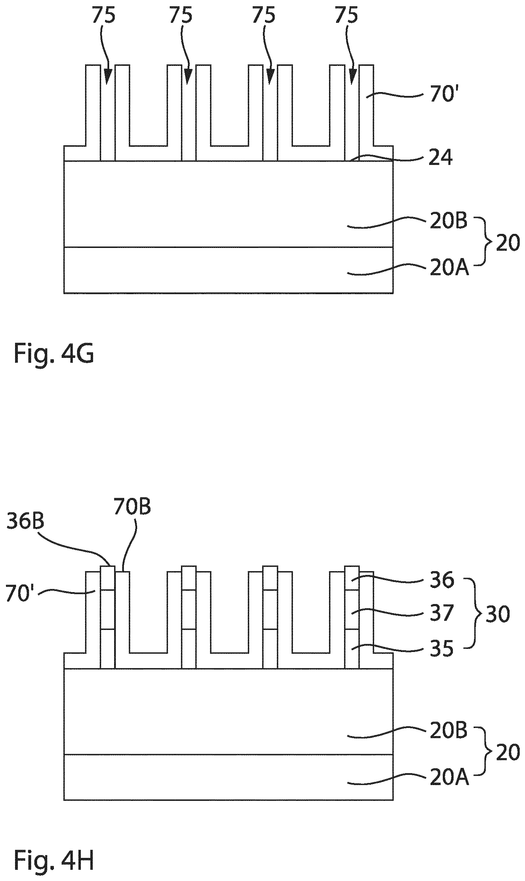

In another method step the plurality of sacrificial structures 65 is removed by selective etching to form a plurality of cavities 75 in the remaining insulating material layer 70', wherein an exposed portion 24 of the first main side 21 is exposed at a bottom of each cavity 75. A structure obtained thereby is shown in FIG. 4G.

In another method step an n-type first silicon carbide layer is formed selectively on the exposed portion 24 of the first main side 21 in each cavity 75 to form the drain layers 35, a p-type second silicon carbide layer is formed selectively on the first silicon carbide layer in each cavity 75 to form the channel layers 37, and an n-type third silicon carbide layer is selectively formed on the second silicon carbide layer in each cavity 75 to form the source layers 36. A structure obtained thereby is shown in FIG. 4H. Exemplarily, an uppermost end surface 70B of the remaining insulating material layer 70' may be located farther away from the first main side 21 than an upper surface 36B of the third silicon carbide layer (source layer 36), i.e. the third silicon carbide layer may extend to a region outside the cavities 75. Alternatively, the uppermost end surface 70B may be located closer to the first main side 21 than the upper surface 36B of the third silicon carbide layer (source layer 36), i.e. all portions of the third silicon carbide layer may be arranged inside the cavity 75. Exemplarily, forming the first silicon carbide layer, forming the second silicon carbide layer and forming the third silicon carbide layer is respectively performed at a temperature below 1400°C. A process for selectively forming a silicon carbide layer only on an exposed portion of the substrate 20 and/or another silicon carbide layer (while no silicon carbide layer is formed on the remaining insulating material layer 70') is well known to a person skilled in the art. Such a process may for example be a selective chemical vapour deposition (CVD), wherein the selectivity of the crystal growth of silicon carbide is obtained by the different chemical behaviour of reactants with different surfaces (here the exposed portion 24 of the first main side 21 or the first silicon carbide layer or the second silicon carbide layer on the one side and the surface of the remaining insulating material layer 70' on the other side). Methods for controlling the polytype of SiC of the first silicon carbide layer, of the second silicon carbide layer and of the third silicon carbide layer during the method step described above is well known to the person skilled in the art. For example when using a CVD process for forming the first silicon carbide layer, the second silicon carbide layer and the third silicon carbide layer, different CVD process parameters such as the temperature have a well-known influence on which polytype of SiC is grown during the CVD process.

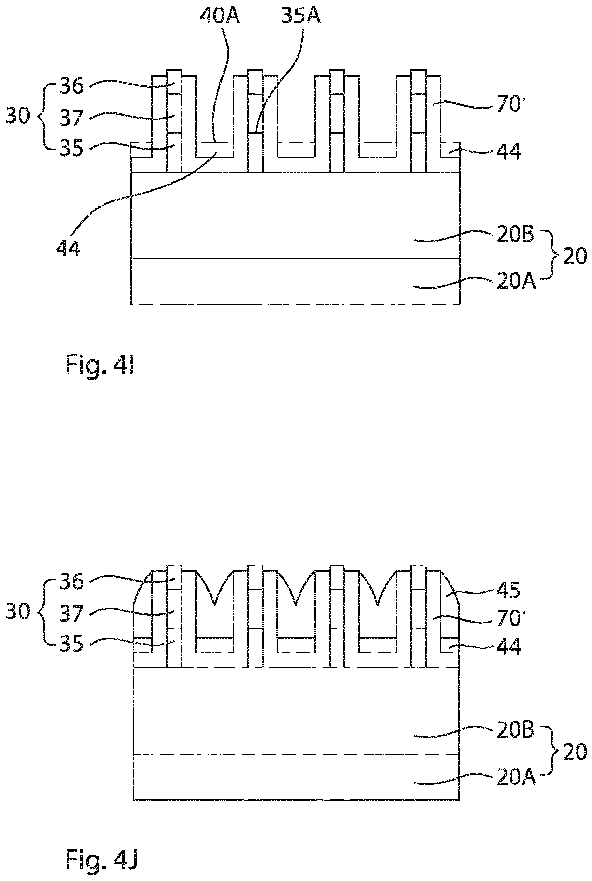

In another method step the second insulating layer 44 is formed on that part of the remaining insulating material layer 70' which forms the second insulating layer portion 43 in the silicon carbide power device 100. A structure obtained thereby is shown in FIG. 4I. The second insulating layer 44 is exemplarily a spin-on-glass (SOG) layer. Alternatively, first a homogenous and continuous layer of another insulation material may be deposited and then structured (exemplarily by etching) to obtain the second insulating layer 44. An upper surface 44A (i.e. a surface facing away from the substrate 20) of the second insulating layer 44 is below an interface 35A between the first silicon carbide layer (forming the drain layers 35 in the silicon carbide power device 100) and the second silicon carbide layer (forming the channel layers 37 in the silicon carbide power device 100).

In another method step the gate electrode layer 45 is formed on that part of the remaining insulating material layer 70' which forms the insulating layer 40 in the silicon carbide power device 100 to obtain a structure as shown in FIG. 4J. Therein, the gate electrode layer 45 is formed directly on a lateral surface of that part of the remaining insulating material layer 70' which forms the first insulating layer portions 42 in the silicon carbide power device 100 and is formed directly on the upper surface 44A of the second insulating layer 44. After forming the gate electrode layer 45, the second insulating layer 44 is sandwiched in a vertical direction perpendicular to the first main side 21 between the remaining insulating material layer 70' and the gate electrode layer 45.

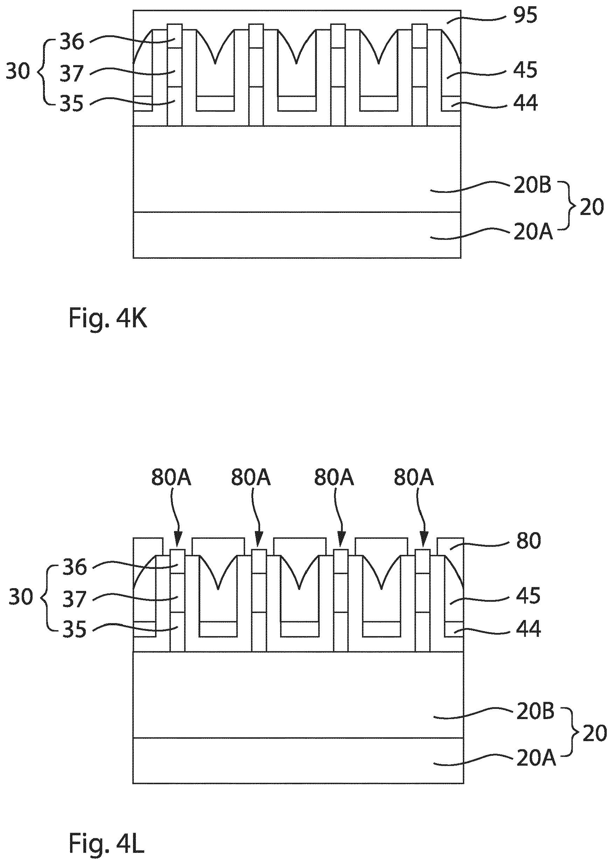

In another method step a homogenous and continuous second insulating material layer 95 is deposited onto the structure shown in FIG. 4J to obtain a structure as shown in FIG. 4K. Thereafter the second insulating material layer 95 is structured to form the intermediate insulating layer 80 exposing the source layers 36 through openings 80A therein as shown in FIG. 4L.

Finally, the first main electrode 52 is formed on the structure shown in FIG. 4L to electrically contact the source layers 36, and the second main electrode 54 is formed on the second main side 22 to obtain the silicon carbide power device 100 as described above with FIGs. 3A to 3D. The method may include additional method steps. For example, additional method steps may be included to form the control contact pad 48 and the source contact pad 56, respectively.

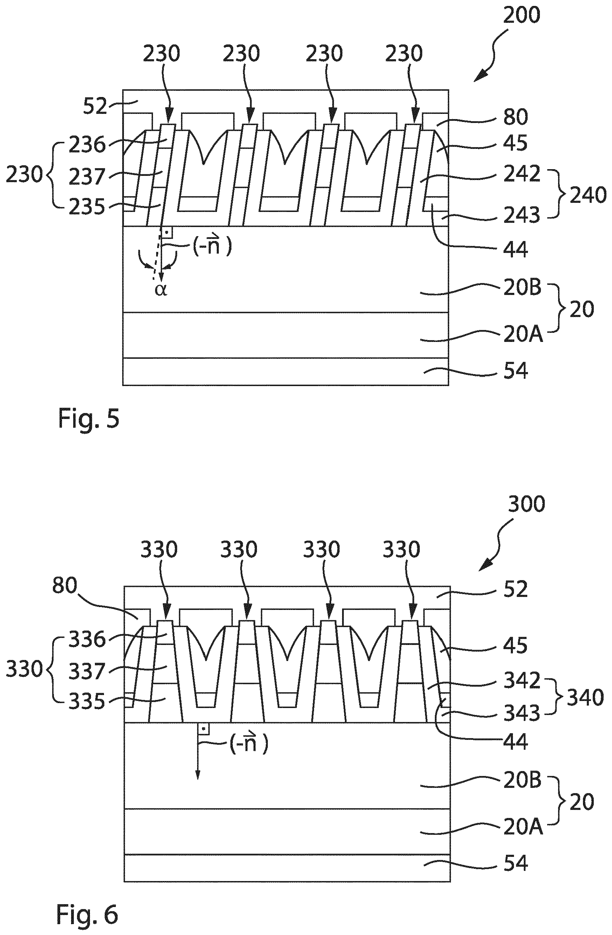

In the following a first modified silicon carbide power device 200 is described with reference to FIG. 5 which shows a vertical cross-section corresponding to the vertical cross-section shown in FIG. 3A. The silicon carbide power device 200 differs from the silicon carbide power device 100 described above only in that the silicon carbide layer stacks 230 are inclined relative to a surface-normal $\vec{n}$ of the first main side 21 (i.e. relative to a direction which is orthogonal to the first main side 21). An inclination angle $\alpha$ of the inclined silicon carbide layer stacks 230 (i.e. of a lateral surface thereof) relative to the surface-normal $\vec{n}$ may be in a range up to 20° for example. Besides the inclination relative to the surface-normal $\vec{n}$ the silicon carbide layer stack 230 is similar to the silicon carbide layer stack 30 and has the same features as described above. Silicon carbide layer stack 230 comprises a drain layer 235, a channel layer 237 and a source layer 236 similar to the drain layer 35, the channel layer 37 and the source layer 36 as described above. In the silicon carbide power device 200 the first insulating layer 240 has a plurality of first insulating layer portions 242 and a second insulating layer portion 243 similar to the first insulating layer 40 as described above. In correspondence with the inclination of the silicon carbide layer stack 230 also lateral surfaces of the first insulating layer portions 242 are inclined relative to the surface normal $\vec{n}$. Otherwise the first insulating layer 240 has the same features as the first insulating layer 40 described above.

A method for manufacturing the silicon carbide power device 200 differs from the method described above with reference to FIGs. 4A to 4L only in that the sacrificial structures 65 have to be inclined relative to surface normal $\vec{n}$ with the inclination angle $\alpha$ in correspondence with the inclination of the silicon carbide layer stacks 230. Such inclination of sacrificial structures 65 can for example be obtained in the step of structuring the sacrificial layer 60 by anisotropic angled etching, such as angled ion beam etching wherein the ion beam is directed towards the sacrificial layer 60 obliquely (i.e. at the angle $\alpha \neq 0°$ relative to the surface normal $\vec{n}$ of the first main side 21).

A silicon carbide power device 300 according to a second modified embodiment is discussed in the following with reference to FIG. 6, which shows a vertical cross-section corresponding to the vertical cross-section shown in FIG. 3A. The silicon carbide power device 300 differs from the silicon carbide power device 100 only in that the silicon carbide layer stacks 330 of the silicon carbide power device 300 are conical in the vertical cross-section with a horizontal width decreasing from a lower end adjacent to the substrate 20 towards an upper end opposite to the lower end. Otherwise, the silicon carbide layer stacks 330 are similar to the silicon carbide layer stacks 30 described above. Each silicon carbide layer stack 330 comprises a drain layer 335, a channel layer 337 and a source layer 336 which are similar to the drain layer 35, the channel layer 37 and the source layer 36 except their inclined lateral surfaces. Other features of the silicon carbide layer stacks 330 than the conical shape in cross-section are the same as described above for the silicon carbide layer stacks 30 of the silicon carbide power device 100. In the silicon carbide power device 300 the first insulating layer 340 has a plurality of first insulating layer portions 342 and a second insulating layer portion 343 similar to the first insulating layer 40 as described above. In correspondence with the conical shape of the silicon carbide layer stack 330 lateral surfaces of the first insulating layer portions 342 are inclined relative to the surface normal $\vec{n}$ of the first main side 21. Otherwise the first insulating layer 340 has the same features as the first insulating layer 40 described above.

A method for manufacturing the silicon carbide power device 300 differs from the method illustrated in FIGs. 4A to 4H only in that the sacrificial structures 65 respectively have, in the vertical cross-section, a conical shape corresponding to the conical shape of the silicon carbide layer stacks 330.

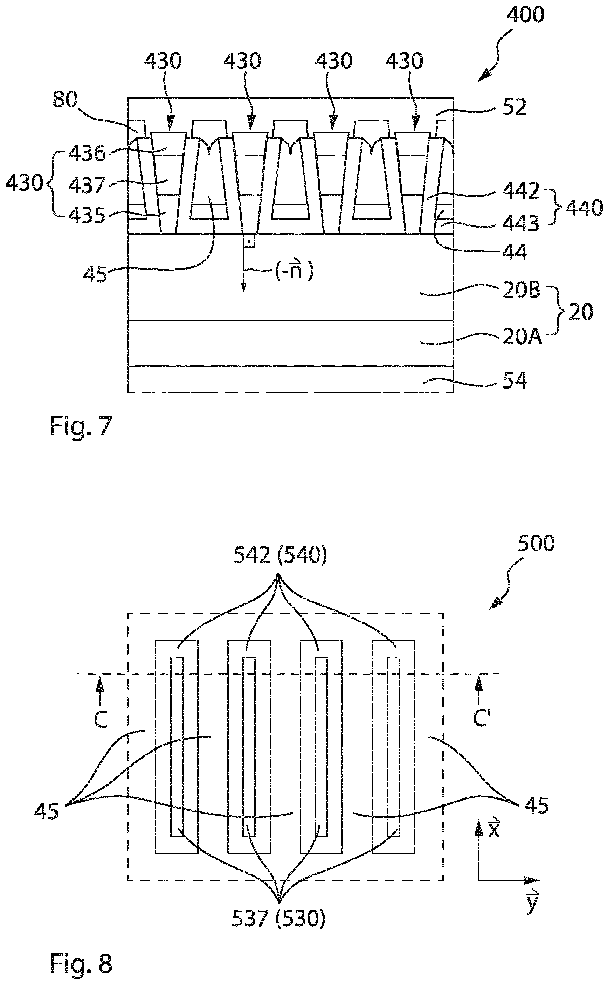

In FIG. 7 it is shown a silicon carbide power device 400 according to a third modified embodiment in a vertical cross-section corresponding to the vertical cross-section shown in FIG. 3A. In this third modified embodiment silicon carbide layer stacks 430 have, in the vertical cross-section, a conical shape with a horizontal width increasing from a lower end adjacent to the substrate 20 towards an upper end opposite to the lower end. The silicon carbide layer stack 430 comprises a drain layer 435, a channel layer 437 and a source layer 436 which are similar to the drain layer 35, the channel layer 37 and the source layer 36 except their inclined lateral surfaces. Other features of the silicon carbide layer stacks 430 than their conical shape in cross-section are the same as described above for the silicon carbide layer stacks 30 of silicon carbide power device 100. In the silicon carbide power device 400 the first insulating layer 440 has a plurality of first insulating layer portions 442 and a second insulating layer portion 443 similar to the first insulating layer 40 as described above. In correspondence with the conical shape of the silicon carbide layer stacks 430 lateral surfaces of the first insulating layer portions 442 are inclined relative to the surface normal $\vec{n}$ of the first main side 21 in a vertical cross-section as shown in FIG. 7. Otherwise the first insulating layer 440 has the same features as the first insulating layer 40 described above.

A method for manufacturing the silicon carbide power device 400 differs from the method illustrated in FIGs. 4A to 4H only in that the sacrificial structures 65 respectively have, in the vertical cross-section, a conical shape corresponding to the conical shape of the silicon carbide layer stacks 430.

In FIG. 8 a silicon carbide power device 500 according to a fourth modified embodiment not covered by the claims but useful for understanding the invention is shown in a horizontal cross-section. The silicon carbide power device 500 is similar to the silicon carbide power device 100 described above and differs therefrom only in a different shape of the silicon carbide layer stacks 530 in horizontal cross-section. While the silicon carbide layer stacks 30 in the silicon carbide power device 100 have the shape of a pillar, the silicon carbide layer stacks 530 in the fourth modified embodiment have the shape of a fin having a relatively large width in a first lateral direction $\vec{x}$ and a relatively small width in a second lateral direction $\vec{y}$ orthogonal to the first lateral direction $\vec{x}$. Accordingly, also a source layer (not shown in FIG. 8), a channel layer 537 and a drain layer (not shown in FIG. 8) of the silicon layer stacks 530 have a corresponding shape. The horizontal cross-section of the silicon carbide power device 500 shown in FIG. 8 corresponds to the horizontal cross-section of the silicon carbide power device 100 shown in FIG. 3D. While the silicon carbide power device 500 differs from the silicon carbide power device 100 in its horizontal cross-section, a vertical cross-section along line C-C' in FIG. 8 is the same as the vertical cross-section of the silicon carbide power device 100 shown in FIG. 3A. Due to the fin shape of the silicon carbide layer stacks 530 also the surrounding first insulating layer portions 542 of the first insulating layer 540 have a corresponding different shape. Otherwise the first insulating layer 540 has features as described above for the first insulating layer 40 of the silicon carbide power device 100. The shape of the fin may exemplarily have a height in the vertical direction larger than a width in one horizontal direction perpendicular to the vertical direction. Exemplarily, the height may be two or three times larger than the width in the one horizontal direction.

A method for manufacturing the silicon carbide power device 500 differs from the method described for manufacturing the silicon carbide power device 100 as described above only in that the sacrificial structures 65 have a different shape, namely a fin shape corresponding to the fin shape of the silicon carbide layer stacks 530.

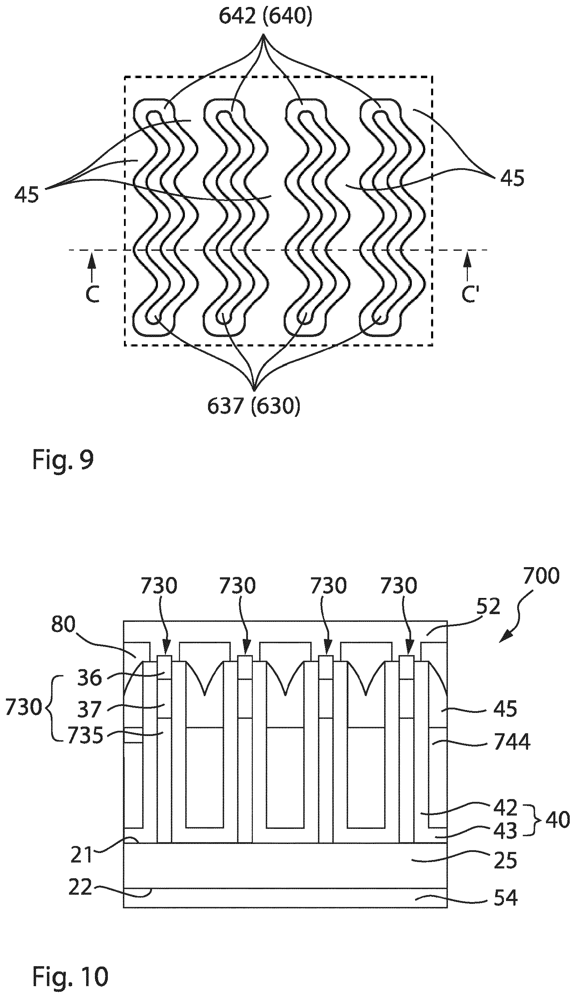

In FIG. 9 a silicon carbide power device 600 according to a fifth modified embodiment not covered by the claims but useful for understanding the invention is shown in a horizontal cross-section corresponding to the horizontal cross-section of FIG. 8. The silicon carbide power device 600 differs from the silicon carbide power device 500 only in that the fin shaped silicon carbide layer stacks 630 are curved as shown in FIG. 9 along a serpentine line instead of being straight along the first lateral direction $\vec{x}$ as the silicon carbide layer stacks 530 in the horizontal cross-section shown in FIG. 8. Accordingly, also a source layer (not shown in FIG. 9), a channel layer 637 and a drain layer (not shown in FIG. 9) of the silicon layer stacks 630 have a corresponding shape. Due to the curved fin shape of the silicon carbide layer stacks 630 also the surrounding first insulating layer portions 642 of the first insulating layer 640 have a corresponding different shape. Otherwise the first insulating layer 640 has features as described above for the first insulating layer 40 of the silicon carbide power device 100. The horizontal cross-section of the silicon carbide power device 600 shown in FIG. 9 corresponds to the horizontal cross-section of silicon carbide power device 100 shown in FIG. 3D. While the silicon carbide power device 600 differs from the silicon carbide power device 100 in its horizontal cross-section, a vertical cross-section along line C-C' in FIG. 9 is the same as the vertical cross-section of the silicon carbide power device 100 shown in FIG. 3A.

A method for manufacturing the silicon carbide power device 600 differs from the method described for manufacturing the silicon carbide power device 100 as described above only in that the sacrificial structures 65 have a different shape, namely a curved fin shape corresponding to the curved fin shape of the silicon carbide layer stacks 630.

In the following a silicon carbide power device 700 according to a sixth modified embodiment is described with reference to FIG. 10 in a vertical cross-section corresponding to the cross-section of FIG. 3A. The silicon carbide power device 700 differs from the above described silicon carbide power device 100 only in that the substrate 25 has a relatively high doping concentration above $10^{17}$ cm$^{-3}$, exemplarily above $5 \cdot 10^{17}$ cm$^{-3}$, and the drain layer (735) of each silicon carbide layer stack 730 is in direct contact with the substrate 25. Accordingly, contrary to the above described silicon carbide power device 100 the substrate 25 does not comprise a two-layered structure having a relatively low doped second substrate layer 20B on a relatively highly doped first substrate layer 20A. While in the silicon carbide power device 100 described above the second substrate layer 20B functions as a drift layer portion common to all transistor cells 50, a whole drift layer of the device is implemented in the drain layer. Exemplarily, the whole drain layer 735 has a doping concentration below $10^{17}$ cm$^{-3}$. For a specific voltage class the drain layer 735 in the silicon carbide power device 700 requires a larger layer thickness in a vertical direction perpendicular to the first main side 21 than the drain layer 35 in the silicon carbide power device 100 for the same voltage class, because in the silicon carbide power device 100 not the whole but only a portion of the drift layer is to be implemented in the drain layer 35. A method for manufacturing the silicon carbide power device 700 differs from the method only in that the substrate 25 instead of the two-layered substrate 20 is provided in a first method step and in that a layer thickness of the second insulating layer 744 may have to be larger than that of the second insulating layer 744 due to the larger layer thickness of the drain layer 735 compared to that of the drain layer 35 in a vertical direction perpendicular to the first main side 21 for a specific voltage class.

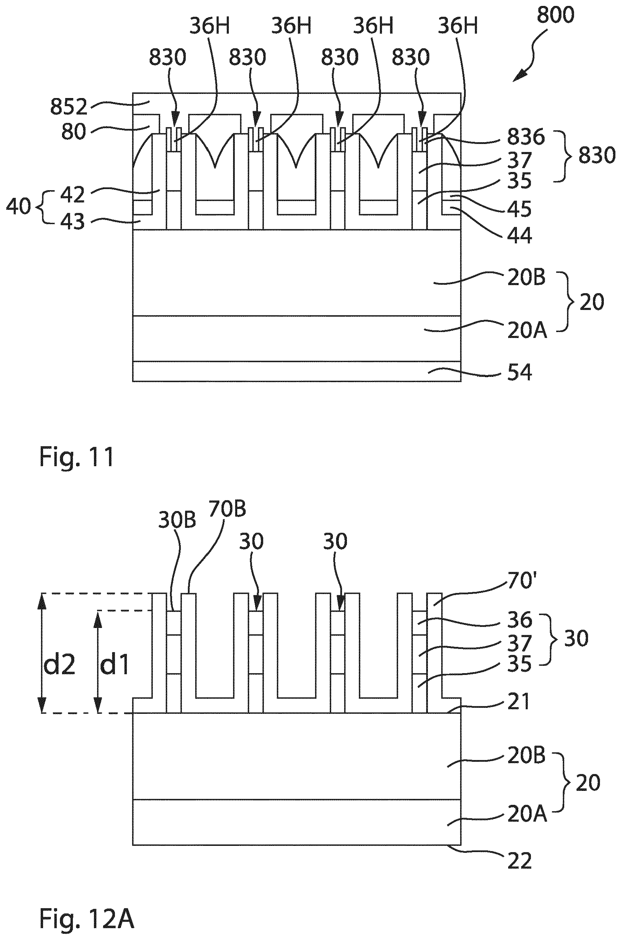

In the following a silicon carbide power device 800 according to a sixth modified embodiment is described with reference to FIG. 11 in a vertical cross-section corresponding to the vertical cross-section of FIG. 3A. The silicon carbide power device 800 differs from the silicon carbide power device 100 described above only in that the first main electrode 852 is in contact with the channel layer 37 through an opening 36H in the source layer 836. The silicon carbide layer stacks 830 are similar to the silicon carbide layer stacks 30 described above. They include a source layer 836 which differs from the source layer 36 only in that it has the opening 36H formed therein through which the first main electrode 852 extends to contact the channel layer 37. Other features of the silicon carbide power device 800 may be the same as that of the silicon carbide power device 100. Alternatively, the remaining features of the silicon carbide power device 800 may be the same as in one of the above described silicon carbide power devices 200, 300, 400, 500, 600 or 700.

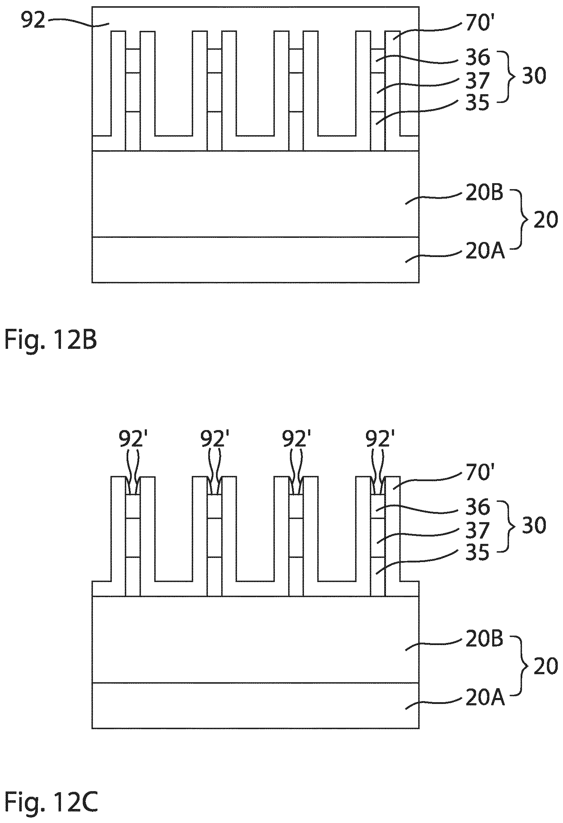

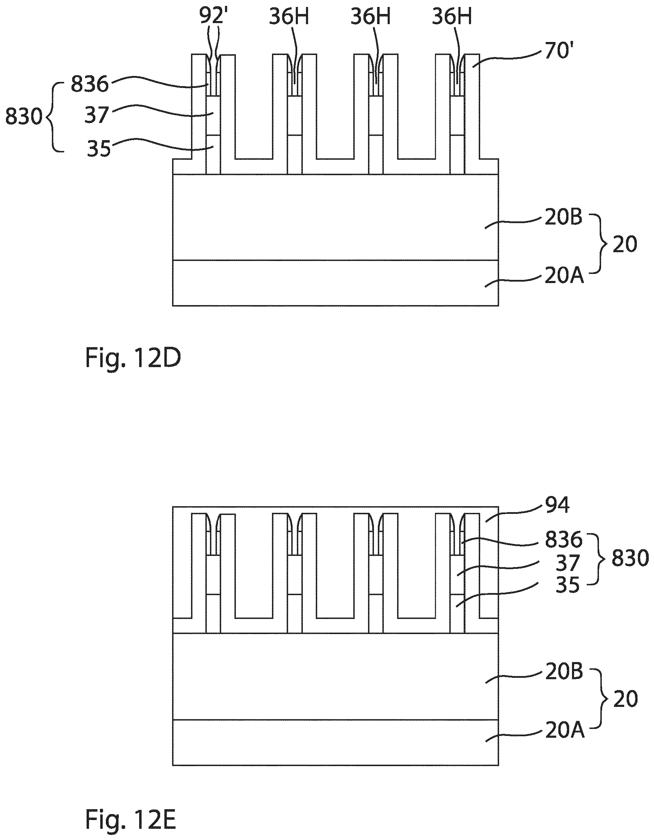

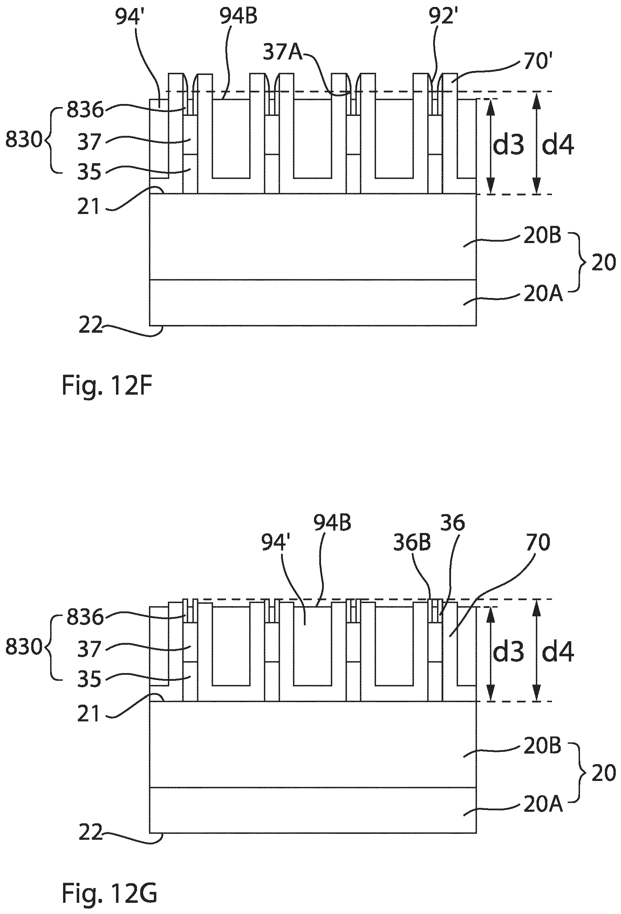

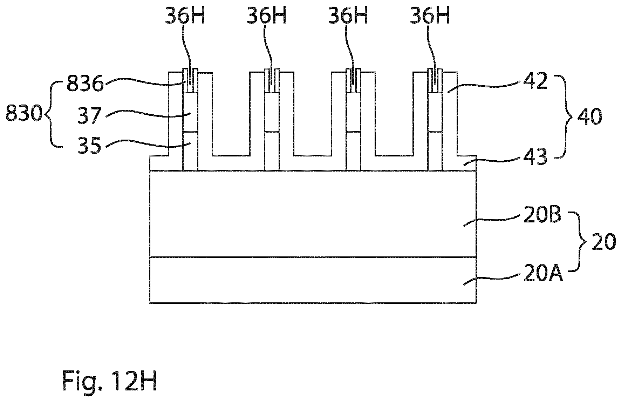

An exemplary embodiment of a method for manufacturing the above described silicon carbide power device 800 is described in the following with reference to FIGs. 12A to 12H, which show vertical cross-sections corresponding to the vertical cross-section of FIG. 11. First method steps as described above with reference to FIGs. 4A to 4G are performed. In another method step thereafter the first silicon carbide layer, the second silicon carbide layer and the third silicon carbide layer are formed selectively in the cavities 75 to obtain the structure as shown in FIG. 12A. An upper surface 30B of the silicon carbide layer stack 30 opposite to the first main side 21 has a distance d1 from the first main side 21 which is smaller than a distance d2 of an uppermost end surface 70B of the remaining insulating material layer 70' from the first main side 21. That means the upper surface 30B of the silicon carbide layer stack 30 is lower than the uppermost end surface 70B of the remaining insulating material layer 70', so that the upper surface 30B of the silicon carbide layer stack 30 and the remaining insulating material layer 70' define a recess with the upper surface 30B of the silicon carbide layer stack 30 forming a bottom of the recess and the remaining insulating material layer 70' forming side walls of the recess. Thereafter a continuous second masking material layer 92 is formed on the remaining insulating material layer 70' and the silicon carbide layer stacks 30 to obtain a structure as shown in FIG. 12B. Then the second masking material layer 92 is structured, e.g. by etching back the second masking material layer 92, to form a second mask layer 92' exposing a first portion of the upper surface 30B of each silicon carbide layer stack 30 while a second portion of the upper surface 30B of the silicon carbide layer stack 30 is covered by the second masking layer 92' as shown in FIG. 12C. Thereafter the second masking layer 92' is used to etch an opening (vertical hole) 36H extending through the source layer 36 of each silicon carbide layer stack and exposing an upper surface portion of the channel layer 37 at a bottom of the opening 36H as shown in FIG. 12D. As shown in FIG. 12E a continuous third masking material layer 94 is then formed on the structure of FIG. 12D. An upper portion of the third masking material layer 94 is then removed e.g. by etching to form a third masking layer 94' exposing at least the second masking layer 92' and an upper end portion of the remaining insulating material layer 70' arranged lateral to the second masking layer 92' as shown in FIG. 12F. An upper surface 94B of the third masking layer 94' is exemplarily as low as or below an interface 37A between the source layer 36 and the channel layer 37, i.e. a distance d3 between the upper surface 94B of the third masking layer 94' and the first main side 21 is the same as or less than a distance d4 between the interface 37A (between the source layer 36 and the channel layer 37) and the first main side 21 in a vertical direction. The second masking layer 92' and the upper end portion of the remaining insulating material layer 70' exposed by the third masking layer 94' are removed by selective etching (selective against SiC) using the third masking layer 94' as an etching mask to obtain a structure as shown in FIG. 12G and the third masking layer 94' is removed to obtain a structure as shown in FIG. 12H. Thereafter, method steps for forming the second insulating layer 44, the gate electrode layer 45, the intermediate insulating layer 80, the gate electrode 45, the first main electrode 852 and the second main electrode 54 are performed in a similar way as described above in the exemplary embodiment of the method for manufacturing the silicon carbide power device 100 to obtain the silicon carbide power device 800 as shown in FIG. 11.

The above described silicon carbide power devices 100-800 are all silicon carbide based power metal-insulator-semiconductor field effect transistors (MISFETs). However, the silicon carbide power device of the invention can also be a different device having the features as defined in the appended claims. For example, the silicon carbide power device may also be an insulated gate bipolar transistor (IGBT) which has an additional p-type semiconductor layer between the substrate 20, 25 and the second main electrode 54.

The above embodiments were explained with specific conductivity types. The conductivity types of the semiconductor layers in each one of the above described embodiments might be switched, so that all layers which were described as p-type layers would be n-type layers and all layers which were described as n-type layers would be p-type layers. For example, in each silicon carbide power device described above the substrate, the drain layer and the source layer could be p-type layers and the source layer could be an n-type layer, respectively. The same applies to all exemplary embodiments of methods for manufacturing the silicon carbide power devices.

In all embodiments discussed above a source layer extends in a region outside cavity 75, i.e. not the whole lateral surface of the source layer is covered with the first insulating layer portion. However, in alternative embodiments the whole lateral surface of the source layer may be covered by the first insulating layer portion.

The features of the different embodiments may be combined with each other. For example the shape of the silicon carbide layer stacks in vertical cross-section as shown in FIGs. 5, 6, 7 or 11 may not only be applied to silicon carbide layer stacks having a pillar shape, but also to the fin-shaped silicon carbide layer stacks as discussed with reference to FIGs. 8 and 9 which are not covered by the claims but useful for understanding the invention. The different substrate structure of the seventh modified embodiment may be used in any other embodiment described above.

A specific method was described for providing an electric contact between the first main electrode 852 and the channel layer 37 with reference to FIGs. 12A to 12H. However, other methods may be applied to provide such electric contact between the first main electrode 852 and the channel layer 37. An electric contact between the first main electrode and the channel layer may be provided also in any one of the above described embodiments. A method for manufacturing a silicon carbide power device with such electric contact between the first main electrode and the channel layer may be any method including a first step of removing a portion of the third silicon carbide layer to expose a portion of the second silicon carbide layer; and thereafter a step of forming a first main electrode electrically contacting the third silicon carbide layer and the second silicon carbide layer, wherein the first main electrode is electrically insulated from the gate electrode layer.

List of reference signs

| 100; 200; 300; 400; 500; 600; 700; 800 | silicon carbide power device |
|---|---|
| 20, 25 | (n-type) substrate |
| 20A | first substrate layer |
| 20B | second substrate layer |
| 21 | first main side |
| 22 | second main side |
| 24 | exposed portion |
| 30; 230; 330; 430; 530; 630; 730; 830 | silicon carbide layer stack |
| 30B | upper surface (of the silicon carbide layer stack 30) |
| 35; 235; 335; 435; 735 | (n-type) drain layer |
| 35A | interface |
| 36; 236; 336; 436; 836 | (n-type) source layer |
| 36B | upper surface (of the source layer 36) |
| 36H | opening (in source layer 836) |
| 37; 237; 337; 437; 537; 637 | (p-type) channel layer |
| 37A | interface |
| 40; 240; 340; 440; 540; 640 | first insulating layer |
| 42; 242; 342; 442; 542; 642 | first insulating layer portion |
| 43; 243; 343; 443 | second insulating layer portion |
| 44, 744 | second insulating layer |
| 44A | upper surface (of the second insulating layer 44) |
| 45 | gate electrode layer |
| 48 | control contact pad |
| 50 | transistor cell |
| 52, 852 | first main electrode |
| 54 | second main electrode |
| 56 | source contact pad |
| 60 | sacrificial layer |
| 65 | sacrificial structure |
| 65A | first end |
| 65B | second end |
| 70 | insulating material layer |
| 70' | remaining insulating material layer |
| 70B | uppermost end surface (of the remaining insulating material layer 70') |
| 75 | cavity |
| 80 | intermediate insulating layer |
| 80A | opening (in the intermediate insulating layer 80) |
| 90 | first masking material layer |
| 90' | first masking layer |

| 92 | second masking material layer |
| 92' | second masking layer |
| 94 | third masking material layer |
| 94' | third masking layer |
| 94B | upper surface (of the third masking layer 94') |
| 95 | second insulating material layer |
| d, d1, d2, d3, d4 | distance |
| L | length |
| w | largest horizontal width |

**Claims**

1. A method for manufacturing a silicon carbide power device (100; 200; 300; 400; 500; 600; 700; 800), the method comprising the following steps:

   providing a first conductivity-type substrate (20; 25);

   forming a sacrificial layer (60) on a first main side (21) of the substrate (20; 25);

   structuring the sacrificial layer (60) to form a plurality of sacrificial structures (65) protruding from the first main side (21) and having a shape of a pillar, wherein each sacrificial structure (65) comprises a first end (65A) adjacent to the substrate (20; 25) and a second end (65B) opposite to the first end (65A);

   forming a continuous insulating material layer (70) on the plurality of sacrificial structures (65) and on the first main side (21);

   thereafter removing a portion of an insulating material layer (70) on the second end (65B) of each sacrificial structure (65) to expose the second end (65B) of each sacrificial structure (65), while the remaining insulating material layer (70') covers a lateral surface of each sacrificial structure (65), wherein at least a part of the remaining insulating material layer (70') forms a first insulating layer (40; 240; 340; 440; 540; 640) in the silicon carbide power device (100; 200; 300; 400; 500; 600; 700; 800);

   thereafter removing each sacrificial structure (65) by selective etching to form a plurality of cavities (75) in the remaining insulating material layer (70'), wherein an exposed portion (24) of the first main side (21) is exposed at a bottom of each cavity (75);

   forming a first silicon carbide layer of the first conductivity-type selectively on the exposed portion (24) of the first main side (21) in each cavity (75) to form the drain layers (35; 235; 335; 435; 735);

   forming a second silicon carbide layer of the second conductivity-type selectively on the first silicon carbide layer in each cavity (75) to form channel layers (37; 237; 337; 437; 537; 637; 737);

   forming a third silicon carbide layer of the first conductivity-type selectively on the second silicon carbide layer in each cavity (75) to form source layers (36; 236; 336; 436; 836); and

   forming a gate electrode layer (45) on that part of the remaining insulating material layer (70') which forms the first insulating layer (40; 240; 340; 440; 540; 640) in the silicon carbide power device (100; 200; 300; 400; 500; 600; 700; 800),

   wherein the finished silicon carbide power device (100; 200; 300; 400; 500; 600; 700; 800) comprises:

   the first conductivity-type substrate (20; 25) having the first main side (21) and a second main side (22) opposite to the first main side (21);

   a plurality of silicon carbide layer stacks (30; 230; 330; 430; 530; 630; 730; 830) arranged on the first main side (21) of the substrate (20; 25), wherein each silicon carbide layer stack (30; 230; 330; 430; 530; 630; 730; 830) comprises the following layers stacked on the first main side (21) in a direction away from the first main side (21): the first conductivity-type drain layer (35; 235; 335; 435; 735) on the substrate (20; 25), the second conductivity-type channel layer (37; 237; 337; 437; 537; 637) on the drain layer (35; 235; 335; 435; 735) and the first conductivity-type source layer (36; 236; 336; 436; 836) on the second conductivity-type channel layer (37; 237; 337; 437; 537; 637), the second conductivity-type being different from the first conductivity-type; the continuous first insulating layer (40; 240; 340; 440; 540; 640), which comprises a plurality of first insulating layer portions (42; 242; 342; 442; 542; 642) respectively extending directly on a lateral surface of a corresponding one of the plurality of silicon carbide layer stacks (30; 230; 330; 430; 530; 630; 730; 830) so that the plurality of first insulating layer portions (42; 242; 342; 442; 542; 642) laterally covers and laterally surrounds at least the drain layer (35; 235; 335; 435; 735) and the channel layer (37; 237; 337; 437; 537; 637; 737) of each silicon carbide layer stack (30; 230; 330; 430; 530; 630; 730; 830), and a second insulating layer portion (43; 243; 343; 443) extending on the first main side (21) between the plurality of first insulating layer portions (42; 242; 342; 442; 542; 642); and

the gate electrode layer (45) extending directly on the first insulating layer (40; 240; 340; 440; 540; 640) such that the gate electrode layer (45) is electrically separated from each one of the plurality of silicon carbide layer stacks (30; 230; 330; 430; 530; 630; 730; 830) by the first insulating layer portions (42; 242; 342; 442; 542; 642),

wherein each one of the plurality of silicon carbide layer stacks (30; 230; 330; 430; 530; 630; 730; 830) has a shape of the pillar protruding from the first main side (21), such that each point of each channel layer (37; 237; 337; 437; 537; 637; 737) is laterally sandwiched between two opposing portions of the gate electrode layer (45), wherein the two opposing portions of the gate electrode layer (45) have a distance (d) of less than 2 $\mu$m along a straight line extending through that point of that channel layer (37; 237; 337; 437; 537; 637; 737).

2. The method according to the preceding claim, wherein the sacrificial layer (60) comprises an amorphous silicon.

3. The method according to any one of the preceding claims, wherein the insulating material layer (70) is formed by thermal oxidation.

4. The method according to any one of the preceding claims, comprising a step of forming a second insulating layer (44; 744) on the remaining insulating material layer (70') before forming the gate electrode layer (45), such that after forming the gate electrode layer (45), the second insulating layer (44; 744) is sandwiched in a vertical direction perpendicular to the first main side (21) between the remaining insulating material layer (70') and the gate electrode layer (45).

5. The method according to the preceding claim, wherein the second insulating layer (44; 744) is a spin-on-glass layer.

6. The method according to any one of the preceding claims, wherein each sacrificial structure (65) has a length (L) in a vertical direction perpendicular to the first main side (21) in a range between 50 nm and 10 $\mu$m, exemplarily in a range between 5 $\mu$m and 10 $\mu$m.

7. The method according to any one of the preceding claims, wherein forming the first silicon carbide layer, forming the second silicon carbide layer and forming the third silicon carbide layer is respectively performed at a temperature below 1400°C.

8. The method according to any one of the preceding claims, wherein the step of removing the portion of the insulating material layer (70) on the second end (65B) of each sacrificial structure (65) comprises a first step of forming a continuous first masking material layer (90) on the insulating material layer (70), a second step of etching back the first masking material layer (90) to form a first masking layer (90') exposing the portion of the insulating material layer (70) on the second end (65B) of each sacrificial structure (65), and a third step of etching the portion of the insulating material layer (70) on the second end (65B) using the first masking layer (90') as an etching mask.

9. The method according to any one of the preceding claims, comprising a step of removing a portion of the third silicon carbide layer to expose a portion of the second silicon carbide layer; and
thereafter a step of forming a first main electrode (852) electrically contacting the third silicon carbide layer and the second silicon carbide layer, wherein the first main electrode (852) is electrically insulated from the gate electrode layer (45).

**Patentansprüche**

1. Verfahren zum Herstellen einer Siliziumcarbid-Leistungsvorrichtung (100; 200; 300; 400; 500; 600; 700; 800), das Verfahren die folgenden Schritte umfassend:

Bereitstellen eines Substrats (20; 25) mit einem ersten Leitfähigkeitstyp;
Ausbilden einer Opferschicht (60) auf einer ersten Hauptseite (21) des Substrats (20; 25);
Strukturieren der Opferschicht (60), um eine Vielzahl von Opferstrukturen (65) auszubilden, die von der ersten Hauptseite (21) vorstehen und eine Gestalt einer Säule aufweisen, wobei jede Opferstruktur (65) ein erstes Ende (65A), das an das Substrat (20; 25) angrenzt, und ein zweites Ende (65B) umfasst, das dem ersten Ende (65A) entgegengesetzt ist;
Ausbilden einer kontinuierlichen Isoliermaterialschicht (70) auf der Vielzahl von Opferstrukturen (65) und auf der ersten Hauptseite (21);

danach Entfernen eines Abschnitts einer Isoliermaterialschicht (70) auf dem zweiten Ende (65B) jeder Opferstruktur (65), um das zweite Ende (65B) jeder Opferstruktur (65) freizulegen, während die verbleibende Isoliermaterialschicht (70') eine laterale Oberfläche jeder Opferstruktur (65) bedeckt, wobei mindestens ein Teil der verbleibenden Isoliermaterialschicht (70') eine erste Isolierschicht (40; 240; 340; 440; 540; 640) in der Siliziumcarbid-Leistungsvorrichtung (100; 200; 300; 400; 500; 600; 700; 800) ausbildet;

danach Entfernen jeder Opferstruktur (65) durch selektives Ätzen, um eine Vielzahl von Hohlräumen (75) in der verbleibenden Isoliermaterialschicht (70') auszubilden, wobei ein freiliegender Abschnitt (24) der ersten Hauptseite (21) an einem Boden jedes Hohlraums (75) freiliegt;

Ausbilden einer ersten Siliziumcarbid-Schicht des ersten Leitfähigkeitstyps selektiv auf dem freiliegenden Abschnitt (24) der ersten Hauptseite (21) in jedem Hohlraum (75), um die Drain-Schichten (35; 235; 335; 435; 735) auszubilden;

Ausbilden einer zweiten Siliziumcarbid-Schicht des zweiten Leitfähigkeitstyps selektiv auf der ersten Siliziumcarbid-Schicht in jedem Hohlraum (75), um Kanalschichten (37; 237; 337; 437; 537; 637; 737) auszubilden;

Ausbilden einer dritten Siliziumcarbid-Schicht des ersten Leitfähigkeitstyps selektiv auf der zweiten Siliziumcarbid-Schicht in jedem Hohlraum (75), um Source-Schichten (36; 236; 336; 436; 836) auszubilden; und

Ausbilden einer Gate-Elektrodenschicht (45) auf demjenigen Teil der verbleibenden Isoliermaterialschicht (70'), der die erste Isolierschicht (40; 240; 340; 440; 540; 640) in der Siliziumcarbid-Leistungsvorrichtung (100; 200; 300; 400; 500; 600; 700; 800) ausbildet,

wobei die fertiggestellte Siliziumcarbid-Leistungsvorrichtung (100; 200; 300; 400; 500; 600; 700; 800) Folgendes umfasst:

das Substrat (20; 25) des ersten Leitfähigkeitstyps, das die erste Hauptseite (21) und eine zweite Hauptseite (22) aufweist, die der ersten Hauptseite (21) entgegengesetzt ist;

eine Vielzahl von Siliziumcarbid-Schichtstapeln (30; 230; 330; 430; 530; 630; 730; 830), die auf der ersten Hauptseite (21) des Substrats (20; 25) angeordnet sind, wobei jeder Siliziumcarbid-Schichtstapel (30; 230; 330; 430; 530; 630; 730; 830) die folgenden Schichten umfasst, die auf der ersten Hauptseite (21) in einer Richtung von der ersten Hauptseite (21) weg gestapelt sind: die Drain-Schicht des ersten Leitfähigkeitstyps (35; 235; 335; 435; 735) auf dem Substrat (20; 25), die Kanalschicht des zweiten Leitfähigkeitstyps (37; 237; 337; 437; 537; 637) auf der Drain-Schicht (35; 235; 335; 435; 735) und die Source-Schicht des ersten Leitfähigkeitstyps (36; 236; 336; 436; 836) auf der Kanalschicht des zweiten Leitfähigkeitstyps (37; 237; 337; 437; 537; 637), wobei der zweite Leitfähigkeitstyp vom ersten Leitfähigkeitstyp verschieden ist;

die kontinuierliche erste Isolierschicht (40; 240; 340; 440; 540; 640), die eine Vielzahl von ersten Isolierschichtabschnitten (42; 242; 342; 442; 542; 642) umfasst, die sich jeweils unmittelbar auf einer lateralen Oberfläche eines entsprechenden der Vielzahl von Siliziumcarbid-Schichtstapeln (30; 230; 330; 430; 530; 630; 730; 830) erstrecken, so dass die Vielzahl von ersten Isolierschichtabschnitten (42; 242; 342; 442; 542; 642) mindestens die Drain-Schicht (35; 235; 335; 435; 735) und die Kanalschicht (37; 237; 337; 437; 537; 637; 737) jedes Siliziumcarbid-Schichtstapels (30; 230; 330; 430; 530; 630; 730; 830) lateral bedeckt und lateral umgibt, und einen zweiten Isolierschichtabschnitt (43; 243; 343; 443) umfasst, der sich auf der ersten Hauptseite (21) zwischen der Vielzahl von ersten Isolierschichtabschnitten (42; 242; 342; 442; 542; 642) erstreckt; und

die Gate-Elektrodenschicht (45), die sich unmittelbar auf der ersten Isolierschicht (40; 240; 340; 440; 540; 640) erstreckt, so dass die Gate-Elektrodenschicht (45) von jedem der Vielzahl von Siliziumcarbid-Schichtstapeln (30; 230; 330; 430; 530; 630; 730; 830) durch die ersten Isolierschichtabschnitte (42; 242; 342; 442; 542; 642) elektrisch getrennt ist,

wobei jeder der Vielzahl von Siliziumcarbid-Schichtstapeln (30; 230; 330; 430; 530; 630; 730; 830) eine Gestalt der Säule aufweist, die von der ersten Hauptseite (21) vorsteht, so dass jeder Punkt jeder Kanalschicht (37; 237; 337; 437; 537; 637; 737) lateral zwischen zwei gegenüberliegenden Abschnitten der Gate-Elektrodenschicht (45) eingefasst ist, wobei die beiden gegenüberliegenden Abschnitte der Gate-Elektrodenschicht (45) einen Abstand (d) von weniger als 2 µm entlang einer geraden Linie aufweisen, die sich durch diesen Punkt dieser Kanalschicht (37; 237; 337; 437; 537; 637; 737) erstreckt.

2. Verfahren nach dem vorhergehenden Anspruch, wobei die Opferschicht (60) ein amorphes Silizium umfasst.

3. Verfahren nach einem der vorhergehenden Ansprüche, wobei die Isoliermaterialschicht (70) durch thermische Oxidation ausgebildet wird.

4. Verfahren nach einem der vorhergehenden Ansprüche, umfassend einen Schritt des Ausbildens einer zweiten Isolierschicht (44; 744) auf der verbleibenden Isoliermaterialschicht (70') vor Ausbilden der Gate-Elektrodenschicht (45), so dass nach Ausbilden der Gate-Elektrodenschicht (45) die zweite Isolierschicht (44; 744) in einer vertikalen Richtung senkrecht zu der ersten Hauptseite (21) zwischen der verbleibenden Isoliermaterialschicht (70') und der Gate-Elektrodenschicht (45) eingefasst ist.

5. Verfahren nach dem vorhergehenden Anspruch, wobei die zweite Isolierschicht (44; 744) eine aufgeschleuderte Glasschicht ist.

6. Verfahren nach einem der vorhergehenden Ansprüche, wobei jede Opferstruktur (65) eine Länge (L) in einer vertikalen Richtung senkrecht zu der ersten Hauptseite (21) in einem Bereich zwischen 50 nm und 10 $\mu$m, beispielsweise in einem Bereich zwischen 5 $\mu$m und 10 $\mu$m, aufweist.

7. Verfahren nach einem der vorhergehenden Ansprüche, wobei Ausbilden der ersten Siliziumcarbid-Schicht, Ausbilden der zweiten Siliziumcarbid-Schicht und Ausbilden der dritten Siliziumcarbid-Schicht jeweils bei einer Temperatur unter 1400 °C durchgeführt wird.

8. Verfahren nach einem der vorhergehenden Ansprüche, wobei der Schritt des Entfernens des Abschnitts der Isoliermaterialschicht (70) auf dem zweiten Ende (65B) jeder Opferstruktur (65) einen ersten Schritt des Ausbildens einer kontinuierlichen ersten Maskierungsmaterialschicht (90) auf der Isoliermaterialschicht (70), einen zweiten Schritt des Zurückätzens der ersten Maskierungsmaterialschicht (90), um eine erste Maskierungsschicht (90') auszubilden, die den Abschnitt der Isoliermaterialschicht (70) auf dem zweiten Ende (65B) jeder Opferstruktur (65) freilegt, und einen dritten Schritt des Ätzens des Abschnitts der Isoliermaterialschicht (70) auf dem zweiten Ende (65B) unter Verwendung der ersten Maskierungsschicht (90') als eine Ätzmaske umfasst.

9. Verfahren nach einem der vorhergehenden Ansprüche, umfassend einen Schritt des Entfernens eines Abschnitts der dritten Siliziumcarbid-Schicht, um einen Abschnitt der zweiten Siliziumcarbid-Schicht freizulegen; und danach einen Schritt des Ausbildens einer ersten Hauptelektrode (852), welche die dritte Siliziumcarbid-Schicht und die zweite Siliziumcarbid-Schicht elektrisch kontaktiert, wobei die erste Hauptelektrode (852) von der Gate-Elektrodenschicht (45) elektrisch isoliert ist.

## Revendications

1. Procédé de fabrication d'un dispositif d'alimentation au carbure de silicium (100 ; 200 ; 300 ; 400 ; 500 ; 600 ; 700 ; 800), le procédé comprenant les étapes suivantes :

fournir un substrat d'un premier type de conductivité (20 ; 25) ;
former une couche sacrificielle (60) sur un premier côté principal (21) du substrat (20 ; 25) ;
structurer la couche sacrificielle (60) pour former une pluralité de structures sacrificielles (65) faisant saillie à partir du premier côté principal (21) et ayant un profil de pilier, chaque structure sacrificielle (65) comprenant une première extrémité (65A) adjacente au substrat (20 ; 25) et une deuxième extrémité (65B) opposée à la première extrémité (65A) ;
former une couche de matériau isolant (70) continu sur la pluralité de structures sacrificielles (65) et sur le premier côté principal (21) ;
après cela retirer une portion d'une couche de matériau isolant (70) sur la deuxième extrémité (65B) de chaque structure sacrificielle (65) pour exposer la deuxième extrémité (65B) de chaque structure sacrificielle (65), tandis que la couche de matériau isolant restante (70') couvre une surface latérale de chaque structure sacrificielle (65), au moins une partie de la couche de matériau isolant restante (70') formant une première couche isolante (40 ; 240 ; 340 ; 440 ; 540 ; 640) dans le dispositif d'alimentation au carbure de silicium (100 ; 200 ; 300 ; 400 ; 500 ; 600 ; 700 ; 800) ;
après cela retirer chaque structure sacrificielle (65) par gravure sélective pour former une pluralité de cavités (75) dans la couche de matériau isolant restante (70'), une portion exposée (24) du premier côté principal (21) étant exposée au niveau d'un fond de chaque cavité (75) ;
former une première couche de carbure de silicium du premier type de conductivité sélectivement sur la portion exposée (24) du premier côté principal (21) dans chaque cavité (75) pour former les couches de drain (35 ; 235 ; 335 ; 435 ; 735) ;
former une deuxième couche de carbure de silicium du deuxième type de conductivité sélectivement sur la première couche de carbure de silicium dans chaque cavité (75) pour former des couches de canal (37 ; 237 ; 337 ; 437 ; 537 ; 637 ; 737) ;

former une troisième couche de carbure de silicium du premier type de conductivité sélectivement sur la deuxième couche de carbure de silicium dans chaque cavité (75) pour former des couches de source (36 ; 236 ; 336 ; 436 ; 836) ; et

former une couche d'électrode grille (45) sur la partie de la couche de matériau isolant restante (70') qui forme la première couche isolante (40 ; 240 ; 340 ; 440 ; 540 ; 640) dans le dispositif d'alimentation au carbure de silicium (100 ; 200 ; 300 ; 400 ; 500 ; 600 ; 700 ; 800),

le dispositif d'alimentation au carbure de silicium (100 ; 200 ; 300 ; 400 ; 500 ; 600 ; 700 ; 800) fini comprenant :

le substrat d'un premier type de conductivité (20 ; 25) ayant le premier côté principal (21) et un deuxième côté principal (22) opposé au premier côté principal (21) ;

une pluralité d'empilements de couches de carbure de silicium (30 ; 230 ; 330 ; 430 ; 530 ; 630 ; 730 ; 830) agencés sur le premier côté principal (21) du substrat (20 ; 25), chaque empilement de couches de carbure de silicium (30 ; 230 ; 330 ; 430 ; 530 ; 630 ; 730 ; 830) comprenant les couches suivantes empilées sur le premier côté principal (21) dans une direction à l'écart du premier côté principal (21) : la couche de drain d'un premier type de conductivité (35 ; 235 ; 335 ; 435 ; 735) sur le substrat (20 ; 25), la couche de canal d'un deuxième type de conductivité (37 ; 237 ; 337 ; 437 ; 537 ; 637) sur la couche de drain (35 ; 235 ; 335 ; 435 ; 735) et la couche de source d'un premier type de conductivité (36 ; 236 ; 336 ; 436 ; 836) sur la couche de canal d'un deuxième type de conductivité (37 ; 237 ; 337 ; 437 ; 537 ; 637), le deuxième type de conductivité étant différent du premier type de conductivité ;

la première couche isolante (40 ; 240 ; 340 ; 440 ; 540 ; 640) continue, qui comprend une pluralité de premières portions de couche isolante (42 ; 242 ; 342 ; 442 ; 542 ; 642) s'étendant respectivement directement sur une surface latérale d'un empilement correspondant de la pluralité d'empilements de couches de carbure de silicium (30 ; 230 ; 330 ; 430 ; 530 ; 630 ; 730 ; 830) de sorte que la pluralité de premières portions de couche isolante (42 ; 242 ; 342 ; 442 ; 542 ; 642) couvre latéralement et entoure latéralement au moins la couche de drain (35 ; 235 ; 335 ; 435 ; 735) et la couche de canal (37 ; 237 ; 337 ; 437 ; 537 ; 637 ; 737) de chaque empilement de couches de carbure de silicium (30 ; 230 ; 330 ; 430 ; 530 ; 630 ; 730 ; 830), et une deuxième portion de couche isolante (43 ; 243 ; 343 ; 443) s'étendant sur le premier côté principal (21) entre la pluralité de premières portions de couche isolante (42 ; 242 ; 342 ; 442 ; 542 ; 642); et

la couche d'électrode grille (45) s'étendant directement sur la première couche isolante (40 ; 240 ; 340 ; 440 ; 540 ; 640) de telle sorte que la couche d'électrode grille (45) soit électriquement séparée de chaque empilement de la pluralité d'empilements de couches de carbure de silicium (30 ; 230 ; 330 ; 430 ; 530 ; 630 ; 730 ; 830) par les premières portions de couche isolante (42 ; 242 ; 342 ; 442 ; 542 ; 642),

chaque empilement de la pluralité d'empilements de couches de carbure de silicium (30 ; 230 ; 330 ; 430 ; 530 ; 630 ; 730 ; 830) a un profil du pilier faisant saillie à partir du premier côté principal (21), de telle sorte que chaque point de chaque couche de canal (37 ; 237 ; 337 ; 437 ; 537 ; 637 ; 737) soit pris en sandwich latéralement entre deux portions opposées de la couche d'électrode grille (45), les deux portions opposées de la couche d'électrode grille (45) ayant une distance (d) inférieure à 2 $\mu$m le long d'une ligne droite s'étendant à travers ce point de cette couche de canal (37 ; 237 ; 337 ; 437 ; 537 ; 637 ; 737).

2. Procédé selon la revendication précédente, dans lequel la couche sacrificielle (60) comprend un silicium amorphe.

3. Procédé selon l'une quelconque des revendications précédentes, dans lequel la couche de matériau isolant (70) est formée par oxydation thermique.

4. Procédé selon l'une quelconque des revendications précédentes, comprenant une étape de formation d'une deuxième couche isolante (44 ; 744) sur la couche de matériau isolant restante (70') avant la formation de la couche d'électrode grille (45), de telle sorte qu'après la formation de la couche d'électrode grille (45), la deuxième couche isolante (44 ; 744) soit prise en sandwich dans une direction verticale perpendiculaire au premier côté principal (21) entre la couche de matériau isolant restante (70') et la couche d'électrode grille (45).

5. Procédé selon la revendication précédente, dans lequel la deuxième couche isolante (44 ; 744) est une couche de verre déposé par centrifugation.

6. Procédé selon l'une quelconque des revendications précédentes, dans lequel chaque structure sacrificielle (65) a une longueur (L) dans une direction verticale perpendiculaire au premier côté principal (21) dans une plage comprise entre 50 nm et 10 $\mu$m, à titre d'exemple dans une plage comprise entre 5 $\mu$m et 10 $\mu$m.

7. Procédé selon l'une quelconque des revendications précédentes, dans lequel la formation de la première couche de carbure de silicium, la formation de la deuxième couche de carbure de silicium et la formation de la troisième couche de carbure de silicium sont respectivement réalisées à une température inférieure à 1 400 °C.

**8.** Procédé selon l'une quelconque des revendications précédentes, dans lequel l'étape consistant à retirer la portion de la couche de matériau isolant (70) sur la deuxième extrémité (65B) de chaque structure sacrificielle (65) comprend une première étape de formation d'une première couche de matériau de masquage (90) continue sur la couche de matériau isolant (70), une deuxième étape de gravure à nouveau de la première couche de matériau de masquage (90) pour former une première couche de masquage (90') exposant la portion de la couche de matériau isolant (70) sur la deuxième extrémité (65B) de chaque structure sacrificielle (65), et une troisième étape de gravure de la portion de la couche de matériau isolant (70) sur la deuxième extrémité (65B) à l'aide de la première couche de masquage (90') comme masque de gravure.

**9.** Procédé selon l'une quelconque des revendications précédentes, comprenant une étape de retrait d'une portion de la troisième couche de carbure de silicium pour exposer une portion de la deuxième couche de carbure de silicium ; et après cela une étape de formation d'une première électrode principale (852) en contact électrique avec la troisième couche de carbure de silicium et la deuxième couche de carbure de silicium, la première électrode principale (852) étant électriquement isolée de la couche d'électrode grille (45).

Fig. 1

Fig. 2

30

36 37 35   30   30   30   100

52
80
A
45
44
42
43 } 40
21
20B } 20
20A
22
54

50   50   50   50

Fig. 3A

100

48
56
56
56

B   B'

Fig. 3B

Fig. 3C

Fig. 3D

60

21

20B ⎫
    ⎬ 20
20A ⎭

22

## Fig. 4A

65B

L

65

65A

20B ⎫
    ⎬ 20
20A ⎭

## Fig. 4B

65B

65

70

65A

20B
20A } 20

Fig. 4C

90

65B

65

70

65A

20B
20A } 20

Fig. 4D

65B

90'

65

70

65A

20B ⎫
        ⎬ 20
20A ⎭

Fig. 4E

65B

65

70'

90'

65A

20B ⎫
        ⎬ 20
20A ⎭

Fig. 4F

Fig. 4G

Fig. 4H

Fig. 4I

Fig. 4J

Fig. 4K

Fig. 4L

Fig. 5

Fig. 6

400

430   430   430   430

80

436
430 { 437
435

45

52

442
443 } 440

44

(-$\vec{n}$)

20B
20A } 20

54

Fig. 7

542 (540)

500

C                    C'

45                                    45

$\vec{x}$

$\vec{y}$

537 (530)

Fig. 8

642 (640)

45

45

637 (630)

Fig. 9

730    730    730    730    700

52

80

36

730    37

735

45

744

42
43    40

21

25

22

54

Fig. 10

Fig. 11

Fig. 12A

Fig. 12B

Fig. 12C

92'  36H  36H  36H

70'

836
830 { 37
35

20B
20

20A

Fig. 12D

94

836
830 { 37
35

20B
20

20A

Fig. 12E

Fig. 12F

Fig. 12G

EP 4 016 645 B1

Fig. 12H

35

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20180350977 A1
- GB 2572442 A
- US 20190165162 A1
- US 20170365665 A1
- US 10056289 B1
- WO 2020114666 A1

**Non-patent literature cited in the description**

- **G.Y. CHUNG**. Improved inversion channel mobility for 4H-SiC MOSFETs following high temperatures anneals in nitric oxide. *IEEE Electron device letters*, April 2001, vol. 22 (4), 176-178